# EUROPEAN PATENT APPLICATION

(11) **EP 4 603 778 A1**
(43) Date of publication of application: **20.08.2025**
(21) Application number: 23876422.9
(22) Date of filing: 08.09.2023
(51) Int. Cl.: F26B 5/04

(54) **DRYING APPARATUS AND METHOD FOR DRYING SUBSTRATE USING SUPERCRITICAL FLUID**

(30) Priority: 14.10.2022 CN 202211262315
(71) Applicant: ACM Research (Shanghai) Inc., Shanghai 201203 (CN)
(72) Inventor: SUN, Yingnan, Shanghai 201203 (CN); YANG, Peixian, Shanghai 201203 (CN); LI, Bin, Shanghai 201203 (CN); HE, Bin, Shanghai 201203 (CN); CHEN, Guoqiang, Shanghai 201203 (CN); JIA, Shena, Shanghai 201203 (CN); ZHANG, Xiaoyan, Shanghai 201203 (CN); WANG, Wenjun, Shanghai 201203 (CN); JIN, Yinhua, Shanghai 201203 (CN); WANG, Hui, Shanghai 201203 (CN)
(74) Representative: Osha BWB
(86) International application number: PCT/CN2023/117639
(87) International publication number: WO 2024/078217

(57) **Abstract**

The present invention discloses a drying apparatus and method for drying a substrate using supercritical fluid. The drying apparatus comprises an upper chamber, a lower chamber, a substrate tray, a lifting mechanism, a connecting assembly and a locking mechanism. The lower chamber is disposed below the upper chamber. The substrate tray is disposed on the lower chamber and is used for carrying the substrate. The lifting mechanism is disposed below the lower chamber and is used for driving the lower chamber to move in the vertical direction, so that the lower chamber is completely contacted with the upper chamber. The connecting assembly is connected to the upper chamber and the lower chamber. The locking mechanism is used to lock or loosen the connecting assembly when the lower chamber is in full contact with the upper chamber. After the locking mechanism locks the connecting assembly and the lifting mechanism withdraws from the lower chamber, the locking mechanism and the connecting assembly automatically contact due to the action of gravity of the chamber, and the upper chamber and the lower chamber are closed to form a sealed chamber. The present invention has the advantage of enhancing the pressure resistance of the sealed chamber.

## Description

### FIELD OF THE INVENTION

The present invention relates to the technical field of semiconductor manufacturing, and more particularly to a drying apparatus and method for drying a substrate using supercritical fluid.

### BACKGROUND

In the process of integrated circuit manufacturing, the wet process of wafer and other substrate is an important process that affects the product yield. In the current wet process, the wafer that needs to be wet etched or cleaned is generally fixed on a wafer chuck, and the wafer is rotated under the drive of the wafer chuck. The surface of the wafer is processed by spraying wet chemical liquid. After the wet etching or cleaning process is completed, it is necessary to perform a drying treatment on the substrate.

It is known that a substrate can be subjected to a drying treatment using supercritical fluid having a surface tension of zero. For example, a substrate covered with isopropyl alcohol (IPA) is transferred from a cleaning chamber to a drying chamber. An upper chamber and a lower chamber of the drying chamber are closed to form a sealed chamber, then supercritical fluid is supplied to the sealed chamber. The IPA on the surface of the substrate dissolves into the supercritical fluid to remove the IPA from the substrate. Then, the supercritical fluid is vaporized and discharged. The sealed chamber is opened after the pressure in the sealed chamber returns to the atmospheric pressure, and finally the dried substrate is taken out.

Since the above-described substrate drying process needs to be performed in a high-pressure and high-temperature environment, it is necessary to ensure the pressure resistance of the sealed chamber. Generally, the drying chamber only uses a bolt to pass horizontally through the side wall of the upper chamber, and clamps the side wall of the lower chamber to lock the sealed chamber. But the bolt is easily broken by the vertical shear force. Therefore, the pressure resistance of the sealed chamber formed by the current drying chamber is low.

### SUMMARY

An object of the present invention is to solve the problem of the low pressure resistance of the sealed chamber of the drying chamber in the prior art. Therefore, the present invention provides a drying apparatus and method for drying a substrate using supercritical fluid, having the advantage of enhancing the pressure resistance of the sealed chamber.

In order to solve the above problem, an embodiment of the present invention provides a drying apparatus for drying a substrate using supercritical fluid, comprising:
an upper chamber and a lower chamber, the lower chamber being disposed below the upper chamber;
a substrate tray, disposed on the lower chamber, used for carrying the substrate;
a lifting mechanism, disposed below the lower chamber, used for driving the lower chamber to move in the vertical direction;
a connecting assembly and a locking mechanism, the connecting assembly being connected to the upper chamber and the lower chamber, the locking mechanism being used for locking or loosening the connecting assembly;
when the lifting mechanism lifts the lower chamber to move upward, so that the lower chamber and the upper chamber are completely contacted, the locking mechanism locks the connecting assembly in the horizontal direction, and a gap is formed between the locking mechanism and the connecting assembly in the vertical direction, when the lifting mechanism withdraws from the lower chamber, the locking mechanism and the connecting assembly contact automatically in the vertical direction, the upper chamber and the lower chamber are closed to form a sealed chamber;
when the sealed chamber is opened, the lifting mechanism firstly lifts the lower chamber to move upward, the gap is formed between the locking mechanism and the connecting assembly in the vertical direction, and the locking mechanism loosens the connecting assembly in the horizontal direction, and the lifting mechanism lifts the lower chamber to move downward.

Another embodiment of the present invention provides a drying apparatus for drying a substrate using supercritical fluid, comprising:
an upper chamber and a lower chamber, the lower chamber being disposed below the upper chamber, and the lower chamber moving relatively with the upper chamber in the vertical direction, so as to be closed to form a sealed chamber;
a substrate tray, disposed on the lower chamber, used for carrying the substrate;
a uniform flow assembly, disposed inside the upper chamber, the uniform flow assembly comprising an annular gas guiding plate and a porous plate, the annular gas guiding plate having a first side surface and a second side surface opposite with each other, and a gas guiding groove penetrating the first side surface and the second side surface, the porous plate being fixed on the first side surface of the annular gas guiding plate, the porous plate comprising a porous structure, and the supercritical fluid being distributed on the upper surface of the substrate by the gas guiding groove and the porous plate sequentially.

Another embodiment of the present invention provides an assembly tooling, for assembling the connecting assembly of the drying apparatus, wherein, the connector of the connecting assembly is a screw rod, and a marking portion is provided on the connector in advance. The assembly tooling comprises:
a tooling body, being fixed to the upper chamber, provided with an assembly opening, and the assembly opening being corresponding to the through holes of the upper chamber and the lower chamber;
a positioning portion, movably provided on the tooling body;
after the connector penetrates the upper chamber and the lower chamber through the assembling opening and the through holes, the positioning portion is matched with the marking portion of the connector by moving the positioning portion, so that the axis of the connector coincides with the axis of the through holes.

Another embodiment of the present invention provides a method of drying a substrate using supercritical fluid, comprising the following steps:
Step S1: place the substrate to be dried on the substrate tray, causing the lower chamber and the upper chamber to move relatively in the vertical direction, so as to be closed into a pressure-resistant sealed chamber;
Step S2: supply the supercritical fluid from the first fluid inlet above the sealed chamber through a first fluid supply pipe, and the fluid bypasses the spoiler below the first fluid inlet and reaches the upper surface of the substrate from the side of the substrate, after the pressure value inside the sealed chamber reaches a set pressure value, stop supplying the supercritical fluid from above the sealed chamber;
Step S3: supply the supercritical fluid from the second fluid inlet of the first side wall of the sealed chamber through the second fluid supply pipe, perform a drying process on the substrate, and discharge the supercritical fluid from the fluid outlet on the second side wall of the sealed chamber;
Step S4: after the drying process is completed, close the second fluid inlet and the fluid outlet, reduce the internal pressure of the sealed chamber, after the supercritical fluid is turned into gas, the gas bypasses the spoiler and is discharged from above the sealed chamber at a predetermined speed through the first fluid inlet;
Step S5: after the internal pressure of the sealed chamber reaches the atmospheric pressure state, open the sealed chamber and take out the substrate.

As described above, the present invention has the following advantages:
The present invention provides a drying apparatus for drying a substrate using supercritical fluid, which adopts connecting assemblies to connect the upper chamber and the lower chamber in the vertical direction. When the lower chamber is completely in contact with the upper chamber in the vertical direction, the drying apparatus adopts locking mechanisms to lock the connecting assemblies in the horizontal direction. After the lifting mechanism withdraws from the lower chamber, the locking mechanisms and the connecting assemblies are automatically contacted up and down in the vertical direction, and the locking mechanisms are also completely in contact with the upper chamber. During the drying process of the substrate, the locking mechanisms and the connecting assemblies are not easily broken by the vertical shear force, thereby enhancing the strength and pressure resistance of the sealed chamber.

The present invention provides a drying apparatus for drying a substrate using supercritical fluid, which adopts a uniform flow assembly arranged inside the upper chamber. The uniform flow assembly comprises a porous plate for the passage of supercritical fluid, so that the fluid distribution in the inlet area of the supercritical fluid is more uniform.

The assembly tooling of the present invention comprises a tooling body and positioning portions, for assembling the connecting assemblies of the drying apparatus. Wherein, the connecting assemblies comprise connectors and fixing members, and the tooling body is fixed to the upper chamber of the drying apparatus and is provided with assembling openings. When the connectors penetrate the upper chamber and the lower chamber of the drying apparatus by the assembly openings, the positioning portions are aligned with the connectors to realize the precise positioning of the connectors, so as to realize an alignment between the fixing members and the bottom of the lower chamber. Hence, the fixing members and the connectors can be accurately fixed at the corresponding position of the bottom of the lower chamber after the fixing members and the connectors are clamped.

The present invention provides a method of drying a substrate using supercritical fluid, which changes the method of discharging the supercritical fluid from a fluid outlet after the supercritical fluid is changed into gas in the prior art. After the substrate drying process is completed, the gas bypasses the spoiler and is discharged above the sealed chamber at a predetermined speed through the first fluid inlet, preventing high-speed gas flow from pulling down pattern structures on the substrate, especially the pattern structures at the edge position of the substrate.

Other features and corresponding benefits of the present invention are described and explained in the later part of the specification, and it is to be understood that at least some of the benefits will become apparent from the description in the specification of the present invention.

### BRIEF DESCRIPTION OF THE DRAWINGS

FIG. 1 is a schematic diagram of a three-dimensional structure of a drying apparatus for drying a substrate using supercritical fluid provided in embodiment 1 of the present invention;
FIG. 2 is a schematic diagram of a three-dimensional structure of a lifting mechanism and supporting members provided in embodiment 1 of the present invention;
FIG. 3 is a schematic structural diagram of a lower chamber fixed to a six-degree-of-freedom robotic platform provided in embodiment 1 of the present invention;
FIG. 4a is a schematic structural diagram of a gear screw transmission mechanism provided in embodiment 1 of the present invention;
FIG. 4b is a schematic structural diagram of another viewing structure of a gear screw transmission mechanism provided in embodiment 1 of the present invention;
FIG. 5a is a schematic diagram of a three-dimensional structure of a drying apparatus for drying a substrate using supercritical fluid that an upper chamber and a lower chamber are opened provided in embodiment 1 of the present invention;
FIG. 5b is a schematic diagram of a three-dimensional structure that the first ends of connectors are fixed to the lower chamber provided in embodiment 1 of the present invention;
FIG. 5c is a schematic diagram of a three-dimensional structure of connectors provided in embodiment 1 of the present invention;
FIG. 5d is a schematic diagram of a three-dimensional structure of the connectors, the first locking blocks, the second locking blocks and the U-shaped clips provided in embodiment 1 of the present invention;
FIG. 6 is a schematic front view of the structure of a drying apparatus for drying a substrate using supercritical fluid that the upper chamber and the lower chamber are opened provided in embodiment 1 of the present invention;
FIG. 7 is a schematic diagram of a three-dimensional structure of a drying apparatus for drying a substrate using supercritical fluid that the upper chamber and the lower chamber are in complete contact, and the locking mechanisms do not lock the connecting assemblies provided in embodiment 1 of the present invention;
FIG. 8a is a schematic diagram of a three-dimensional structure of a drying apparatus based on supercritical fluid that the upper chamber and the lower chamber are in complete contact, and the locking mechanisms lock the connecting assemblies provided in embodiment 1 of the present invention;
FIG. 8b is a schematic diagram of a three-dimensional structure of an eddy current displacement sensor provided in embodiment 1 of the present invention;
FIG. 8c is a schematic view of the side structure of the eddy current displacement sensor installed on the drying apparatus provided in embodiment 1 of the present invention;
FIG. 9 is a schematic front view of the structure of a drying apparatus for drying a substrate using supercritical fluid that the upper chamber and the lower chamber are in complete contact, and the locking mechanisms lock the connecting assemblies provided in embodiment 1 of the present invention;
FIG. 10 is a schematic front view of the structure of a drying apparatus for drying a substrate using supercritical fluid that a lifting mechanism withdraws from the lower chamber provided in embodiment 1 of the present invention;
FIG. 11 is a schematic cross-sectional structural view of a drying apparatus for drying a substrate using supercritical fluid that an upper chamber and a lower chamber are closed to form a sealed chamber provided in embodiment 1 of the present invention;
FIG. 12 is a partial enlarged view of portion A of FIG. 11;
FIG. 13 is a partial enlarged view of portion B of FIG. 12;
FIG. 14 is a schematic diagram of a three-dimensional structure of a drying apparatus for drying a substrate using supercritical fluid that an upper chamber and a lower chamber are closed to form a sealed chamber provided in embodiment 1 of the present invention;
FIG. 15 is schematic top view of the structure of a drying apparatus for drying a substrate using supercritical fluid that an upper chamber and a lower chamber are closed to form a sealed chamber provided in embodiment 1 of the present invention;
FIG. 16 is a schematic diagram showing a working principle of detecting the concentration of a target substance discharged from a sealed chamber by the analyzer provided in embodiments 1 and 3 of the present invention;
FIG. 17 is a schematic diagram of a three-dimensional structure of the upper chamber provided in embodiment 1 of the present invention;
FIG. 18 is a partial enlarged view of portion C of FIG. 17;
FIG. 19 is a schematic diagram of a three-dimensional structure of a uniform flow assembly and wedge blocks provided in embodiment 1 of the present invention;
FIGS. 20a and 20b are schematic views of a three-dimensional structure of the wedge blocks provided at both ends of the uniform flow assembly provided in embodiment 1 of the present invention;
FIG. 21 is a schematic view of a three-dimensional structure of an annular gas guiding plate and a porous plate provided in embodiment 1 of the present invention;
FIG. 22 is a partial enlarged view of a sintered mesh provided in embodiment 1 of the present invention;
FIG. 23 is a partial enlarged view of portion D of FIG. 22;
FIG. 24 is a partial enlarged view of a porous structure of the porous plate provided in embodiment 1 of the present invention;
FIG. 25 is a schematic diagram of a three-dimensional structure of a sealing strip provided in embodiment 1 of the present invention;
FIG. 26 is a schematic diagram of an internal structure of the upper chamber provided in embodiment 1 of the present invention;
FIG. 27 is a schematic cross-sectional view of the upper chamber along the direction E-E' of FIG. 26;
FIG. 28 is a partial enlarged view of portion F of FIG. 27;
FIG. 29 is a schematic cross-sectional structural diagram of the first bodies of the upper chamber and the lower chamber nested in the second bodies provided in an embodiment of embodiment 1 of the present invention;
FIG. 30 is a schematic diagram of a three-dimensional structure of the first body of the upper chamber provided in an embodiment of embodiment 1 of the present invention;
FIG. 31 is a schematic diagram of a three-dimensional structure of the second body of the upper chamber provided in an embodiment of embodiment 1 of the present invention;
FIG. 32 is a schematic diagram of a three-dimensional structure of the first body of the lower chamber provided in an embodiment of embodiment 1 of the present invention;
FIG. 33 is a schematic diagram of a three-dimensional structure of the second body of the lower chamber provided in an embodiment of embodiment 1 of the present invention;
FIG. 34 is a schematic bottom view of the first body of the upper chamber nested in the second body of the upper chamber provided in another embodiment of embodiment 1 of the present invention;
FIG. 35 is a schematic top view of the first body of the lower chamber nested in the second body of the upper chamber provided in another embodiment of embodiment 1 of the present invention;
FIG. 36 is a schematic front view of a structure of an integral form of the first bodies and the second bodies of the upper chamber and the lower chamber provided in embodiment 1 of the present invention;
FIG. 37 is a schematic diagram of a three-dimensional structure of a drying apparatus for drying a substrate using supercritical fluid that an upper chamber and a lower chamber are opened provided in embodiment 2 of the present invention;
FIG. 38 is a schematic diagram of a three-dimensional structure of a drying apparatus for drying a substrate using supercritical fluid that the upper chamber and the lower chamber are in complete contact, and the locking mechanisms do not lock the connecting assemblies provided in embodiment 2 of the present invention;
FIG. 39 is a schematic diagram of a three-dimensional structure of a drying apparatus for drying a substrate using supercritical fluid that the upper chamber and the lower chamber are in complete contact, and the locking mechanisms lock the connecting assemblies provided in embodiment 2 of the present invention;
FIG. 40 is a schematic diagram of a three-dimensional structure that the first ends of the connectors are fixed to the lower chamber provided in embodiment 2 of the present invention;
FIG. 41 is a schematic diagram of a three-dimensional structure of a drying apparatus for drying a substrate using supercritical fluid that an upper chamber and a lower chamber are closed to form a sealed chamber provided in embodiment 3 of the present invention;
FIG. 42 is a schematic cross-sectional structural view of a drying apparatus for drying a substrate using supercritical fluid that an upper chamber and a lower chamber are closed to form a sealed chamber provided in embodiment 3 of the present invention;
FIG. 43 is a partial enlarged view of portion G of FIG. 42;
FIG. 44 is a flowchart of detecting the concentration of oxygen in a method of drying a substrate using supercritical fluid provided in embodiment 3 of the present invention;
FIGS. 45 and 46 are flowcharts of detecting the concentration of isopropyl alcohol in a method of drying a substrate using supercritical fluid provided in embodiment 3 of the present invention;
FIGS. 47a and 47b are views of the pressure in the sealed chamber varies with time provided in embodiment 3 of the present invention;
FIG. 48 is a schematic diagram of a three-dimensional structure that an assembly tooling is fixed to the upper chamber provided in embodiment 5 of the present invention;
FIG. 49 is a partial enlarged view of positioning portions of the assembly tooling before alignment with the connectors provided in embodiment 5 of the present invention;
FIG. 50 is a partial enlarged view of positioning portions of the assembly tooling after alignment with the connectors provided in embodiment 5 of the present invention;
FIG. 51 is a schematic view of a three-dimensional structure from another perspective that the assembly tooling is fixed to the upper chamber provided in embodiment 5 of the present invention;
FIG. 52 is a schematic top view of the structure before the assembly tooling positions the connectors provided in embodiment 5 of the present invention; and
FIG. 53 is a schematic top view of the structure after the assembly tooling positions the connectors provided in embodiment 5 of the present invention.

### PREFERRED EMBODIMENTS OF THE INVENTION

Hereinafter, the embodiments of the present invention will be described with reference to specific embodiments, and other advantages and effects of the present invention will be readily apparent to those skilled in the art from the disclosure of the present specification. Although the description of the present invention will be described in conjunction with preferred embodiments, this does not mean that the features of the invention are limited to these embodiments. On the contrary, the purpose of the description in connection with the embodiments is to cover other alternatives or modifications that may be extended based on the claims of the invention. In order to provide an in-depth understanding of the present invention, many specific details will be included in the following description. The present invention may also be practiced without these details. Furthermore, in order to avoid confusion or obscuring the focus of the present invention, some specific details will be omitted in the description. It should be described that the embodiments of the present invention and the features of the embodiments may be combined with each other as long as there is no conflict.

It should be noted that in the present specification, similar numerals and letters refer to similar items in the following drawings. Hence, once an item is defined in one drawing, it is not necessary to further define and explain the item in the following drawings.

Hereinafter, the technical solutions of the present invention will be clearly and completely described with reference to the accompanying drawings, and it is obvious that the described embodiments are some embodiments of the present invention, but not all embodiments. Based on the embodiments in the present invention, all other embodiments obtained by those of ordinary skill in the art without making creative efforts belong to the scope of protection of the present invention.

In the description of the present invention, it should be noted that the orientation or positional relationship indicated by the terms "center", "upper", "lower", "left", "right", "vertical", "horizontal", "inner", "outer" are based on the orientation or positional relationship shown in the accompanying drawings. And the term is only for convenience and simplification of the description of the present invention, and does not indicate or imply that the referred apparatus or element must have a specific orientation or be constructed and operated in a specific orientation. Therefore, the terms cannot be understood as a limitation of the present invention. Furthermore, the terms "first", "second" and "third" are used for describing purposes only and cannot be understood to indicate or imply relative importance.

In the description of the present invention, it should be noted that unless otherwise explicitly specified and defined, the terms "mounted", "connected" and "jointed" should be understood in a broad sense, for example, may be fixed connection, may be detachable connection, or may be integral connection. The connection may also be mechanical connection or electrical connection. The connection can be direct connection, indirect connection through an intermediate medium, or the internal connection of two elements. The specific meanings of the above terms in the present invention will be understood by those of ordinary skill in the art.

In order to clarify the objects, technical solutions and advantages of the present invention, the embodiments of the present invention will be described in further details below with reference to the accompanying drawings.

### First embodiment

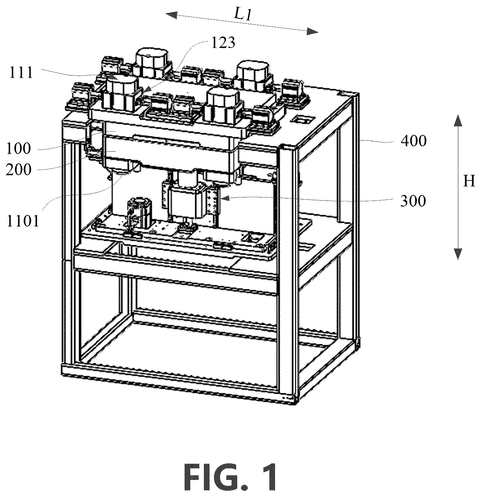

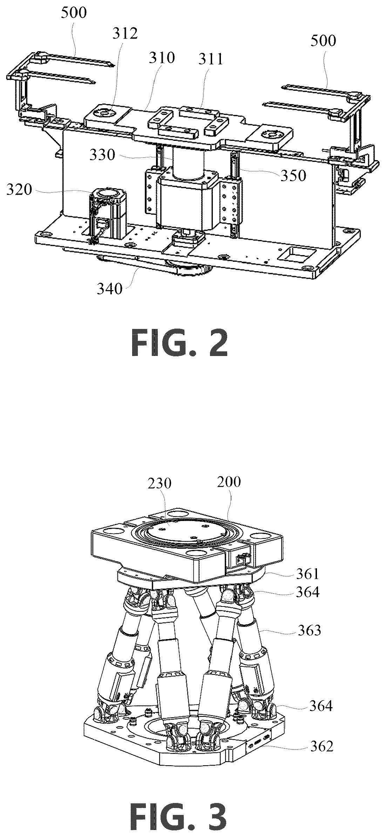

Referring to FIG. 1, the present invention provides a drying apparatus for drying a substrate using supercritical fluid, comprising an upper chamber 100, a lower chamber 200, a lifting mechanism 300, a substrate tray 230 (please refer to the substrate tray 230 in FIG. 3), connecting assemblies and locking mechanisms 123. The lower chamber 200 is disposed below the upper chamber 100, and the lifting mechanism 300 is disposed below the lower chamber 200, and is used to drive the lower chamber 200 to move in the vertical direction H. The substrate tray 230 is disposed in the lower chamber 200, and is used to carry the substrate. The connecting assemblies are connected to the upper chamber 100 and the lower chamber 200, and the locking mechanisms 123 are used to lock or loosen the connecting assemblies.

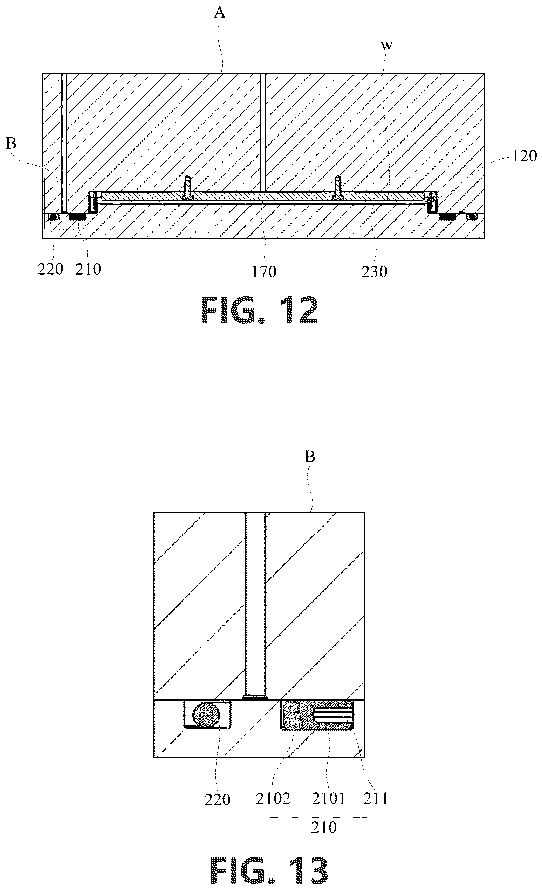

When the lifting mechanism 300 lifts the lower chamber 200 to move upward, the lower chamber 200 and the upper chamber 100 are fully contacted. The locking mechanisms 123 lock the connecting assemblies in the horizontal direction L, and a gap is formed between the locking mechanisms 123 and the connecting assemblies in the vertical direction H. When the lifting mechanism 300 withdraws from the lower chamber 200, the locking mechanisms 123 and the connecting assemblies contact automatically in the vertical direction H without gap. The upper chamber 100 and the lower chamber 200 are closed to form a sealed chamber 120 (please refer to the sealed chamber 120 in FIG. 12). In the present embodiment, the upper chamber 100 is fixed to a frame 400 to keep the upper chamber 100 fixed without moving, and the lower chamber 200 moves upward in the vertical direction H to fully contact the upper chamber 100.

When it is necessary to open the sealed chamber 120, the lifting mechanism 300 firstly lifts the lower chamber 200 to move upward. The above-mentioned gap is formed again in the vertical direction H between the locking mechanisms 123 and the connecting assemblies. The locking mechanisms 123 slide in the horizontal direction L to loosen the connecting assemblies, and then the lifting mechanism 300 lifts the lower chamber 200 to move downward.

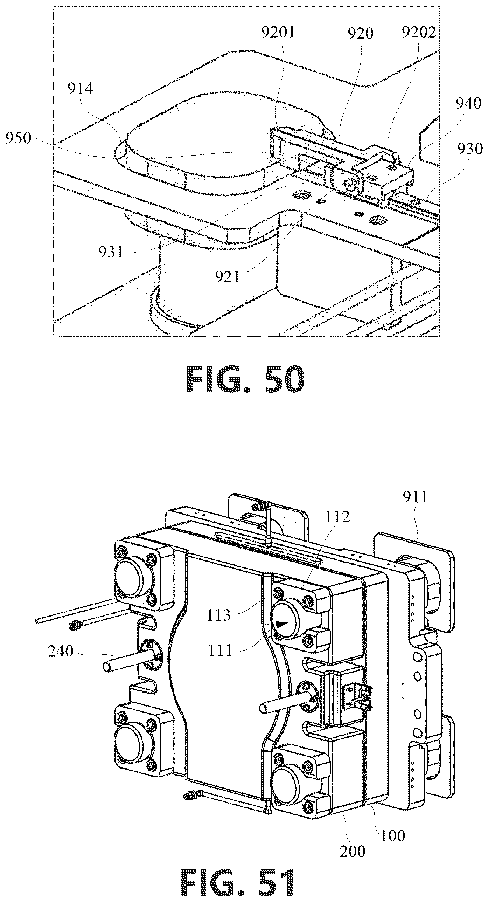

Referring to FIG. 2, the lifting mechanism 300 comprises a lifting platform 310, a transmission apparatus and a driving apparatus 320. The lifting platform 310 is disposed below the lower chamber 200 and is used to lift the lower chamber 200. Guiding shafts 240 (please refer to the guiding shafts 240 in FIG. 51) are provided at the bottom of the lower chamber 200, and flexible pads 311 and linear bearings 312 are provided on the lifting platform 310. The linear bearings 312 cooperate with the guiding shafts 240, so that the position of the lower chamber 200 does not shift during the movement of the lifting mechanism 300 to lift the lower chamber 200. The flexible pads 311 may be made of PTFE (Polytetrafluoroethylene) materials, and the flexible pads 311 are in contact with the lower chamber 200, for a fine-tuning of the parallelism of the lower chamber 200 when the lower chamber 200 and the upper chamber 100 are closed. In other embodiments, the flexible pads 311 may be replaced with cardan shafts. The transmission apparatus comprises a screw rod 330, a timing pulley and a timing belt 340, and the driving apparatus 320 may be a servo motor. Specifically, the output end of the servo motor is connected to the timing pulley, and is connected to the timing pulley at one end of the screw rod 330 through the timing belt 340. The servo motor drives the screw rod 330 to move linearly through the timing pulley and the timing belt 340. The servo motor uses linear guiding rails 350 as a guide to realize the lifting and lowering of the lifting platform 310.

In some embodiments, the lifting mechanism 300 comprises a six-degree-of-freedom robotic platform, a gear screw transmission mechanism, a servo hydraulic system, an electric cylinder or a pneumatic cylinder.

Referring to FIG. 3, the lifting mechanism 300 is, for example, a six-degree-of-freedom robotic platform comprising an upper platform 361, a lower platform 362, telescopic cylinders 363 and Hooke hinges 364. The lower chamber 200 is provided on the upper platform 361 of the six-degree-of-freedom robotic platform. The guiding shafts 240 may be provided at the bottom of the lower chamber 200, and the linear bearings (not shown in the figure) matched with the guiding shafts 240 may be provided on the upper platform 361. The upper platform 361 and the lower platform 362 are connected by six telescopic cylinders 363 and Hooke hinges 364, and the Hooke hinges 364 are located at the connection position of the telescopic cylinders 363 connecting the upper platform 361 and the lower platform 362. The lower chamber 200 is lifted and lowered in the vertical direction by the cooperative action of the six telescopic cylinders 363. In the process of lifting the lower chamber 200 by the six-degree-of-freedom robotic platform, the cooperative action of the six telescopic cylinders 363 can ensure the parallelism of the upper platform 361 and the lower platform 362, thereby ensuring the parallelism of the lower chamber 200.

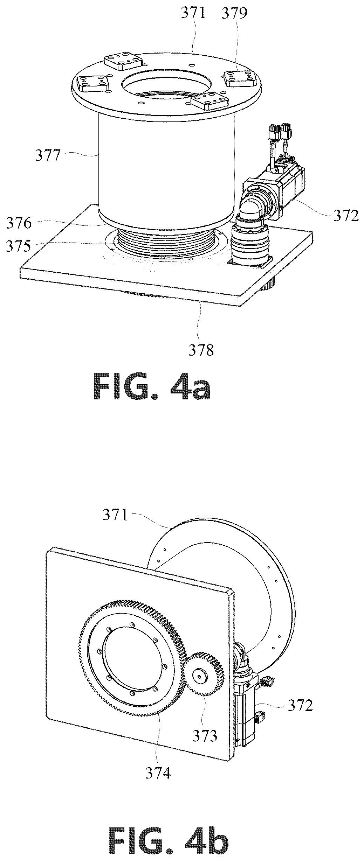

In connection with FIGS. 4a and 4b, the lifting mechanism 300 is, for example, a gear screw transmission mechanism comprising a liftable platform 371, a driving motor 372, a driving wheel 373, a driven wheel 374, a screw pole 375, a screw nut 376, an outer supporting ring 377 and a base 378. The working principle of the gear screw transmission mechanism for lifting the lower chamber 200 is as follows: The lower chamber 200 is provided on the liftable platform 371, and the liftable platform 371 has flexible cushions 379 for contacting the lower chamber 200. The flexible cushions 379 can be made of PTFE materials, and the bottom of the lower chamber 200 can be provided with guiding shafts 240. The linear bearings (not shown in the figure) matched with the guiding shafts 240 can be provided on the liftable platform 371, and the driving motor 372 drives the driving wheel 373 to rotate. The driving wheel 373 drives the driven wheel 374 to rotate through the meshing action and drives the screw pole 375 to rotate. The screw nut 376 is converted into linear motion with the rotation of the screw pole 375. The liftable platform 371 is connected to the screw nut 376 through the outer supporting ring 377 to realize the corresponding linear motion, and the lower chamber 200 moves linearly with the liftable platform 371.

Referring to FIG. 2, the drying apparatus further comprises supporting members 500 for holding up the substrate w (please refer to the substrate w in FIG. 12) and loading the substrate w onto the substrate tray 230, or taking out the substrate w from the substrate tray 230.

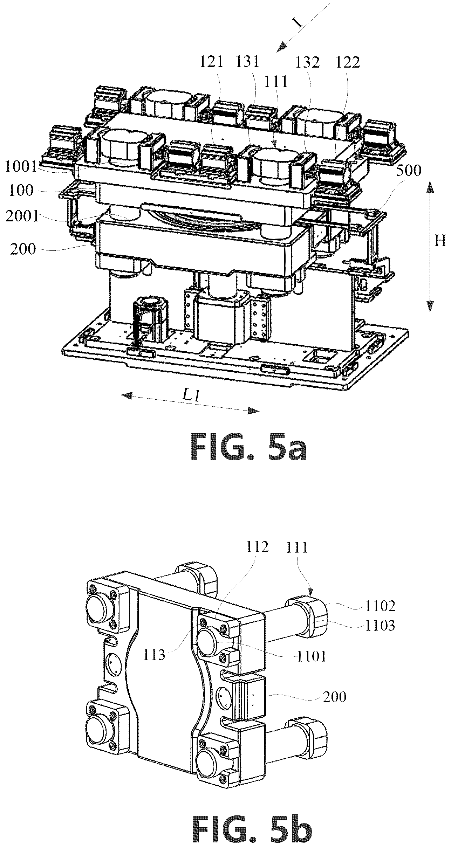

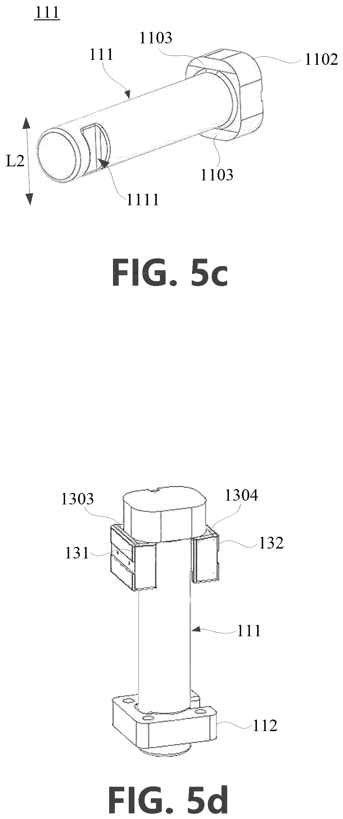

In connection with FIGS. 5a to 5d, the connecting assemblies comprise connectors 111 and fixing members. The upper chamber 100 is provided with through holes 1001, and the lower chamber 200 is provided with via holes 2001. The connectors 111 penetrate the upper chamber 100 and the lower chamber 200 through the through holes 1001 of the upper chamber 100 and the via holes 2001 of the lower chamber 200. The first ends 1101 of the connectors 111 are fixed to the lower chamber 200 by the fixing members, and the second parts 1102 of the connectors 111 and the locking mechanisms 123 contact automatically or form a gap with each other in the vertical direction H.

The locking mechanisms 123 are provided on the upper chamber 100, and the locking mechanisms 123 comprise first driving portions 121, first locking blocks 131, second driving portions 122 and second locking blocks 132 on both sides of the connectors. The first driving portions 121 drive the first locking blocks 131, and the second driving portions 122 drive the second locking blocks 132, so that the first locking blocks 131 and the second locking blocks 132 move relatively or backward in the horizontal direction L1 to lock or loosen the connecting assemblies. In the present embodiment, the first locking blocks 131 have the same structure as the second locking blocks 132. The first locking blocks 131 have self-chaining surfaces 1303, and the second locking blocks 132 have self-latching surfaces 1304. The first driving portions 121 and the second driving portions 122 may all be cylinders.

Specifically, connectors 111 are screw rods, and the fixing members are clamped with the first ends 1101 of the screw rods and fixed at the bottom of the lower chamber 200. Specifically, fixing members comprise U-shaped clips 112 and screws 113, the first end 1101 of each screw rod is provided with two opposite clamping slots 1111. After the first ends 1101 of the screw rods pass through the bottom of the lower chamber 200, the U-shaped clips 112 are clamped in the two clamping slots 1111, and the openings of the U-shaped clips 112 are outward. The U-shaped clips 112 have screw holes, and the screws 113 pass through the screw holes to fix the U-shaped clips 112 at the bottom of the lower chamber 200. The first ends 1101 of the screw rods are fixed to the lower chamber 200 by the U-shaped clips 112 and the screws 113. The connection mode of fixing the screw rods on the lower chamber 200 has a reliable structure, and the first ends 1101 of the screw rods can bear large local stress, so that the fatigue life of the screw rods are long. The second parts 1102 of the screw rods are screw caps, and the bottom of the screw caps are provided with self-locking surfaces 1103. When the upper chamber 100 and the lower chamber 200 are closed to form a sealed chamber 120, the self-locking surfaces 1103 of the screw rods are in complete contact with the self-chaining surfaces (1303, 1304) of the first locking blocks 131 and the second locking blocks 132 in the vertical direction H without gap.

In the present embodiment, four connecting assemblies are provided, which are respectively located at four corners of the upper chamber 100 and the lower chamber 200. In other embodiments, the number of connecting assemblies may be six, and the present invention does not limit the number of connecting assemblies.

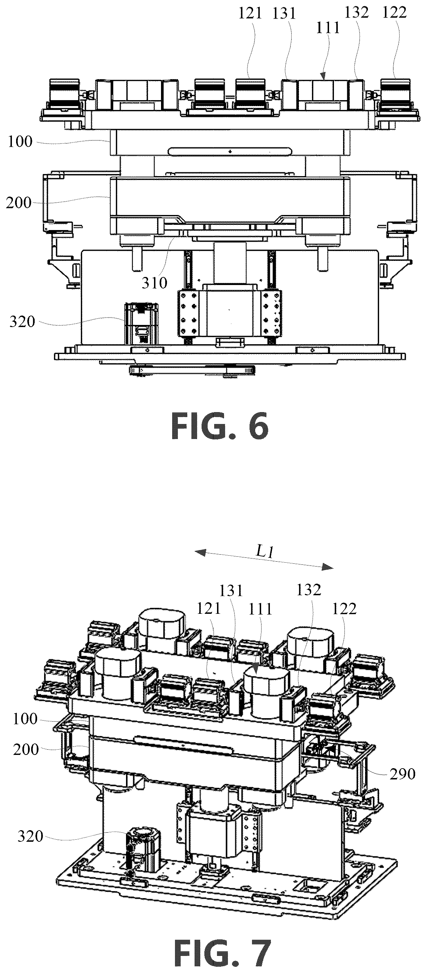

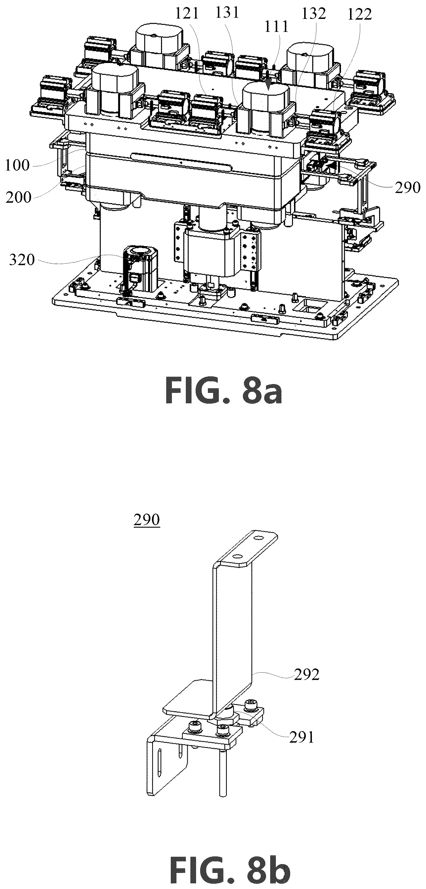

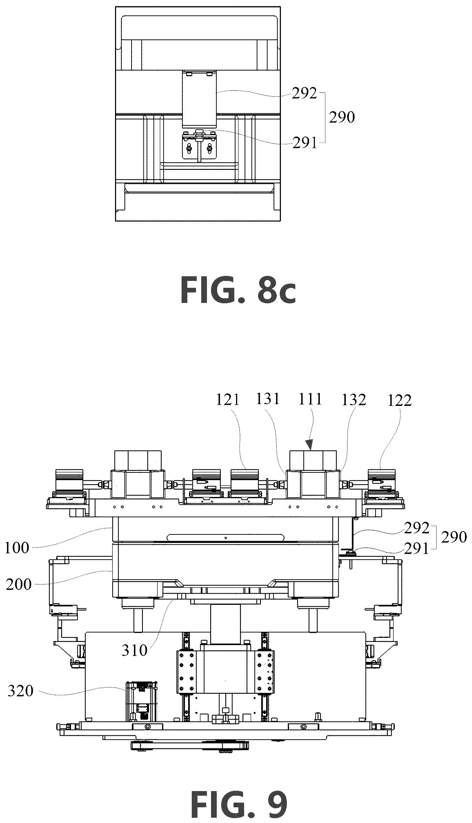

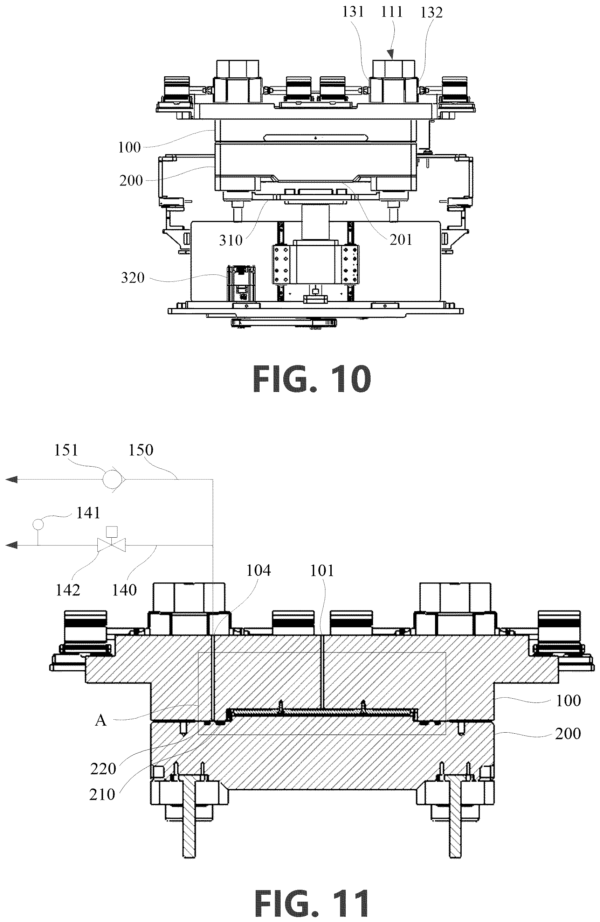

Specifically, with reference to FIGS. 5a to 10, the substrate w is placed in the supporting members 500 in the I direction. After placing the substrate w on the substrate tray 230, the supporting members 500 exit the lower chamber 200. The upper chamber 100 is fixed to the frame 400 without moving, and the driving apparatus 320 drives the lifting platform 310 to lift the lower chamber 200 upward, so that the lower chamber 200 moves upward in the vertical direction H until the lower chamber 200 is in complete contact with the upper chamber 100 (as shown in FIG. 7). Then the first driving portions 121 and the second driving portions 122 on both sides of the screw rods drive the first locking blocks 131 and the second locking blocks 132 respectively to move relatively in the horizontal direction L1 on the top wall surface of the upper chamber 100, so as to lock the screw rods (as shown in FIGS. 8a and 9). At this time, a gap is formed between the self-chaining surfaces (1303, 1304) of the first locking blocks 131 and the second locking blocks 132 and the self-locking surfaces 1103 of the screw rods. When the lifting platform 310 leaves the bottom 201 of the lower chamber 200 and descends (as shown in FIG. 10), the upper chamber 100 and the lower chamber 200 rebound due to the downward deformation or the gravity action of the lower chamber 200 and the action of the elastic sealing between the upper chamber 100 and the lower chamber 200. The self-chaining surfaces (1303, 1304) of the first locking blocks 131 and the second locking blocks 132 are in complete contact with the self-locking surfaces 1103 of the screw rods without gap (that is, the locking mechanisms 123 and the connecting assemblies contact automatically in the vertical direction), and the upper chamber 100 and the lower chamber 200 are closed to form a sealed chamber 120. At this time, the first locking blocks 131 and the second locking blocks 132 are closely matched with the screw rods to ensure the pressure resistance and sealing of the sealed chamber 120.

Similarly, when the sealed chamber 120 is to be opened, the driving apparatus 320 drives the lifting platform 310 to move upward. When the lifting platform 310 contacts the lower chamber 200 and lifts the lower chamber 200 to move upward, the lower chamber 200 and the upper chamber 100 are fully contacted again. A gap is formed again between the self-chaining surfaces (1303, 1304) of the first locking blocks131 and the second locking blocks 132 and the self-locking surfaces 1103 of the screw rods, so that the first locking blocks 131 and the second locking blocks 132 can slide out smoothly. Then, the first driving portions 121 and the second driving portions 122 respectively drive the first locking blocks 131 and the second locking blocks 132 to move away from the screw rods in the horizontal direction L1 on the top wall of the upper chamber 100, so as to loosen the screw rods. Then the driving apparatus 320 drives the lifting platform 310 to lift the lower chamber 200 to move downward, and the sealed chamber120 is opened.

In the present embodiment, the horizontal direction L1 in which the first locking blocks 131 and the second locking blocks 132 lock the screw rods is parallel to the longitudinal direction L2 of the two clamping slots 1111. In other alternative embodiments, the horizontal direction L1 in which the first locking blocks 131 and the second locking blocks 132 lock the screw rods is perpendicular to the longitudinal direction L2 of the two clamping slots 1111. For these two embodiments, when the substrate drying process is performed in the drying apparatus, the magnitude of the stress at the position corresponding to the first locking blocks 131 and the second locking blocks 132 on the screw rods is basically the same as the magnitude of the stress at the position corresponding to the U-shaped clips 112.

In addition, in the present embodiment, the horizontal direction L1 is the longitudinal direction of the upper chamber 100. The horizontal direction in which the first locking blocks 131 and the second locking blocks 132 lock the screw rods is the same as the longitudinal direction of the upper chamber 100. And in other alternative embodiments, the horizontal direction in which the first locking blocks 131 and the second locking blocks 132 lock the screw rods may also be the diagonal direction of the upper chamber 100. For example, the first driving portions 121 and the second driving portions 122 on both sides of the screw rods respectively drive the first locking blocks 131 and the second locking blocks 132 to move relatively or backward in the diagonal direction of the upper chamber 100 on the top wall of the upper chamber 100, so as to lock or loosen the screw rods. Correspondingly, the longitudinal direction L2 of the two clamping slots 1111 can be adaptively adjusted.

As shown in FIGS. 8a to 9, the drying apparatus further comprises a sensor 290 configured to judge whether the upper chamber 100 and the lower chamber 200 are closed (in full contact) by detecting the distance between the upper chamber 100 and the lower chamber 200. As shown in FIG. 8b, in the present embodiment, the sensor 290 is an eddy current displacement sensor, and the eddy current displacement sensor comprises a probe 291 and a measurement object 292. The measurement object 292 is a metal conductor, and the probe 291 is fixed to one side wall of the lower chamber 200. The measurement object 292 is fixed to one side wall of the upper chamber 100, and the measurement object 292 and the probe 291 are vertically corresponding to each other. When the driving apparatus 320 drives the lifting platform 310 to lift the lower chamber 200 to continue to move upward, the eddy current displacement sensor accurately measures the distance between the measurement object 292 and the end face of the probe 291 through the principle of the eddy current effect, so as to obtain the distance between the upper chamber 100 and the lower chamber 200. Furthermore, it can be judged whether the elastic sealing members (such as the inner sealing rings 210 in FIG. 11) between the upper chamber 100 and the lower chamber 200 are pressed. If the elastic sealing members are pressed, it means that the upper chamber 100 and the lower chamber 200 are closed (fully contacted). And then the first driving portions 121 and the second driving portions 122 respectively drive the first locking blocks 131 and the second locking blocks 132 to lock the connectors 111. If not, it means that the upper chamber 100 and the lower chamber 200 have not been closed, and the driving apparatus 320 drives the lifting platform 310 to lift the lower chamber 200 to continue to move upward.

In connection with FIGS. 11 to 13, the above-described elastic sealing members are specifically inner sealing rings 210 and outer sealing rings 220. The inner sealing rings 210 and the outer sealing rings 220 are sequentially arranged around the substrate tray 230, and are used to seal the sealed chamber 120 when the lower chamber 200 and the upper chamber 100 are closed to form the sealed chamber 120 by relative movement.

Wherein, the longitudinal cross sections of the inner sealing rings 210 are U-shaped, and the springs 211 are provided inside the inner sealing rings 210. When the upper chamber 100 and the lower chamber 200 are closed, the inner sealing rings 210 are closely fitted to the upper chamber 100 and the lower chamber 200 by the inner springs 211, so as to achieve preliminary sealing. When the sealed chamber 120 is sealed and detected without leakage, the supercritical fluid is introduced, and the high-pressure gas in the sealed chamber 120 enters and squeezes the inside of the U-shaped openings of the inner sealing rings 210. Hence, the upper and lower ends of the U-shaped openings of the inner sealing rings 210 are squeezed and deformed and pressed against at least one of the upper chamber 100 and the lower chamber 200. The inner sealing rings 210 are further fitted to the upper chamber 100 and the lower chamber 200. Even if the upper chamber 100 and the lower chamber 200 are slightly deformed, the elastic inner sealing rings 210 and the outer sealing rings 220 can ensure good sealing performance of the sealed chamber 120.

As shown in FIG. 13, the inner sealing rings 210 comprise front portions 2101 and rear portions 2102. The front portions 2101 of the inner sealing rings 210 are made of PTFE, and the rear portions 2102 of the inner seal rings 210 are made of PEEK (Polyetheretherketone). The rear portions 2102 have higher hardness and can resist greater pressure.

As shown in FIG. 11, when the upper chamber 100 and the lower chamber 200 are closed to form the sealed chamber 120, a cavity (not shown in the figure) is formed between the inner sealing rings 210 and the outer sealing rings 220. The vacuum pumping pipeline 140 is connected to the cavity through a vacuum pumping inlet 104 on the top wall of the upper chamber 100, so as to perform a vacuum pumping on the cavity. The vacuum pumping pipeline 140 is provided with a pressure detector 141, which is, for example, a pressure sensor. When the pressure detected by the pressure sensor reaches the target pressure, it represents a completion of the sealing. At this time, the supercritical fluid may be supplied in the sealed chamber 120.

The pressure sensor is communicatively connected to the host computer (not shown in the figure) to send the detected pressure signal of the cavity between the inner sealing rings 210 and the outer sealing rings 220 to the host computer. And during the process of detection using the pressure sensor, when there is a significant change in the pressure of the pressure sensor received by the host computer, the vacuum pumping is stopped. After stopping the vacuum pumping, if the pressure of the pressure sensor received by the host computer increases slightly and is less than or equal to the atmospheric pressure, the host computer determines that the sealing performances of the outer sealing rings 220 have failed. At this time, the drying process in the sealed chamber 120 is not affected, and the outer sealing rings 220 can be maintained after the current drying process is completed.

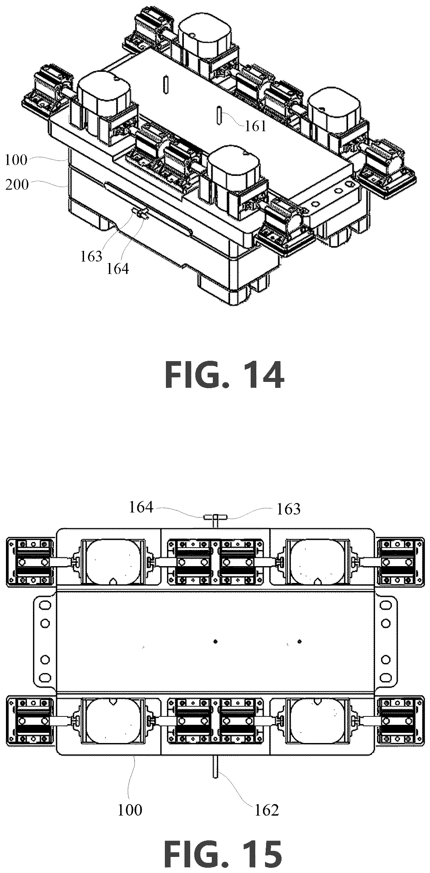

After stopping the vacuum pumping, if the pressure of the pressure sensor received by the host computer is greater than the atmospheric pressure, the host computer determines that the inner sealing rings 210 have failed. The leaked supercritical fluid is discharged from the one-way pipeline 150 provided with a one-way valve 151 and the fluid discharge pipe 163 (please refer to the fluid discharge pipe 163 in FIG. 14). At this time, the drying process is stopped, and when the pressure in the sealed chamber 120 reaches the atmospheric pressure state, the inner sealing rings 210 can be checked and replaced. The one-way pipeline 150 is connected to the vacuum pumping inlet 104 and is connected in parallel with the vacuum pumping pipeline 140. In the present embodiment, the outlet of the one-way pipeline 150 is combined with the outlet of the fluid discharge pipe 163. Under normal circumstances, the one-way valve 151 of the one-way pipeline 150 can prevent other discharge pipes, such as the gas of fluid discharge pipe 163 from escaping into the vacuum pumping pipeline 140.

After stopping the vacuum pumping, if the pressure of the pressure sensor received by the host computer is greater than the working pressure of the safe range of the pressure sensor, it means that the leakage amount of the supercritical fluid is large. And the host computer controls the pneumatic valve 142 on the vacuum pumping pipeline 140 to be closed to protect the pressure sensor. At this time, the drying process is stopped, and when the pressure in the sealed chamber 120 reaches the atmospheric pressure state, the inner sealing rings 210 can be checked and replaced.

In connection with FIGS. 11, 14 and 15, the drying apparatus further comprises a first fluid supply pipe 161, a second fluid supply pipe 162 and a fluid discharge pipe 163.

The first fluid supply pipe 161 is connected to the first fluid inlet 101 on the top wall of the upper chamber 100, and is used to supply the supercritical fluid to the inside of the sealed chamber 120. The continuous addition of the supercritical fluid continuously increases the pressure inside the sealed chamber 120, until the sealed chamber 120 increases the pressure above the critical pressure of the supercritical fluid to reach a supercritical state.

In connection with FIGS. 11, 12 and 14, a spoiler 170 is disposed below the first fluid inlet 101 and between the first fluid inlet 101 and the substrate w, so that the supercritical fluid entering from the first fluid supply pipe 161 and the first fluid inlet 101 reaches the upper surface of the substrate w from the side of the substrate w after bypassing the spoiler 170, effectively buffering the impulse force of the supercritical fluid. It is avoided that the supercritical fluid with an excessive flow rate is directly sprayed onto the upper surface of the substrate w, thereby blowing off the IPA on the surface of the substrate w.

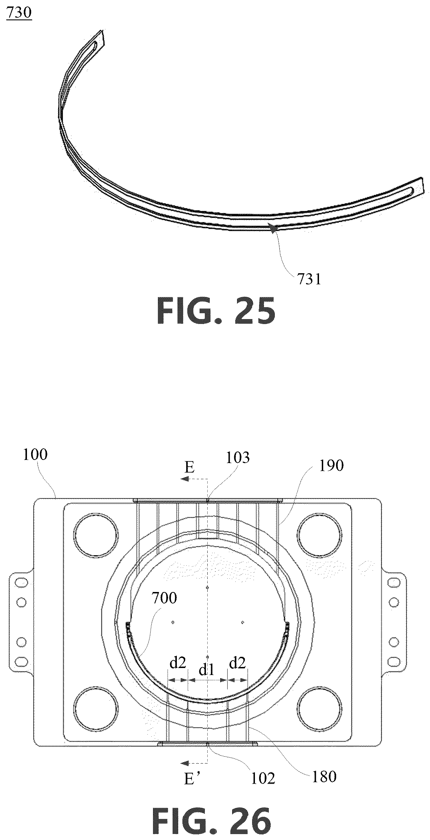

The second fluid supply pipe 162 is connected to the second fluid inlet 102 (please refer to the second fluid inlet 102 in FIG. 26) on the first side wall of the upper chamber 100, for supplying the supercritical fluid to the inside of the sealed chamber 120 in a supercritical state, so that the supercritical fluid is replaced with IPA that covers the surface of the substrate w. The surface of the substrate w inside the sealed chamber 120 is subjected to a drying treatment.

The fluid discharge pipe 163 is connected to a fluid outlet 103 (please refer to the fluid outlet 103 in FIG. 26) on the second side wall of the upper chamber 100.

Wherein, when opening the first fluid supply pipe 161, with the supply of the supercritical fluid, the gas and fluid inside the sealed chamber 120 are discharged from the sealed chamber 120 through the fluid discharge pipe 163, so that all the gas inside the sealed chamber 120 can be replaced with fluid. And the supply of the supercritical fluid is continuously increased, so that the pressure inside the sealed chamber 120 rises above the critical pressure. When the inside of the sealed chamber 120 reaches a supercritical state, the first fluid supply pipe 161 is closed, and the supply of the supercritical fluid from above the sealed chamber 120 is stopped.

When opening the second fluid supply pipe 162, the substrate w inside the sealed chamber 120 is dried by the supercritical fluid, and at this time, the fluid discharged from the fluid discharge pipe 163 is the supercritical fluid.

After the drying process is completed, the second fluid supply pipe 162 can be closed, and the fluid inside the sealed chamber 120 is continuously discharged through the fluid discharge pipe 163, thereby reducing the internal pressure of the sealed chamber 120. Hence, the supercritical fluid inside the sealed chamber 120 becomes gas, and is discharged from the sealed chamber 120 from the fluid outlet 103 through the fluid discharge pipe 163.

In connection with FIGS. 14 to 16, the drying apparatus further comprises a residual gas sampling pipe 164, an analyzer 630 and a controller. The residual gas sampling pipe 164 and the fluid discharge pipe 163 are connected to the fluid outlet 103 through a three-way valve. The analyzer 630 is connected to the residual gas sampling pipe 164, for detecting the concentration of the target substance discharged from the sealed chamber 120 in real time. The controller is used to control the process parameters of the drying apparatus according to the concentration of the target substance detected by the analyzer 630. The target substance is oxygen or isopropyl alcohol (IPA).

Specifically, the analyzer 630 is a residual gas analyzer (RGA), and the controller comprises a process command system 640 and a process control system 650. The supercritical fluid in the residual gas sampling pipe 164 enters the vacuum chamber 620 through the sampling system 610, and the temperature control system 611 controls the temperature of the sampling system 610 to keep the supercritical fluid in the sampling system 610 in a gaseous state, so as to prevent liquefaction and condensation. Then, the vacuum pumping system 622 performs a vacuum pumping on the vacuum chamber 620 to maintain a set vacuum degree, and the vacuum chamber 620 can be heated. The temperature control system 621 controls the temperature of the vacuum chamber 620 to maintain the supercritical fluid in the vacuum chamber 620 in a gaseous state, so as to prevent liquefaction and condensation. Then, the analyzer 630 performs a qualitative and quantitative analysis on the components of the supercritical fluid sample in the vacuum chamber 620, so as to obtain the concentration of the target substance. The analyzer 630 feeds back the analysis result to the process command system 640. The process command system 640 commands the process control system 650 to make timely adjustments to the process parameters of the drying apparatus, for example, the process control system 650 maintains, reduces, or increases the pressure inside the sealed chamber 120 by controlling the supply or discharge amount of the supercritical fluid.

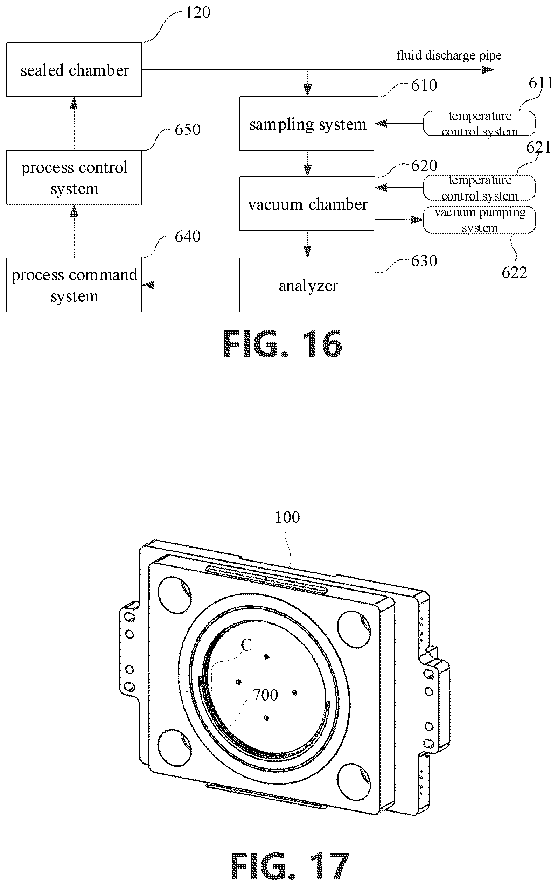

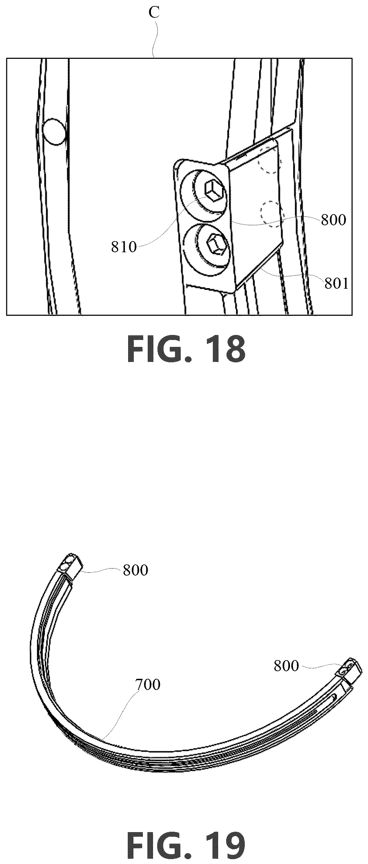

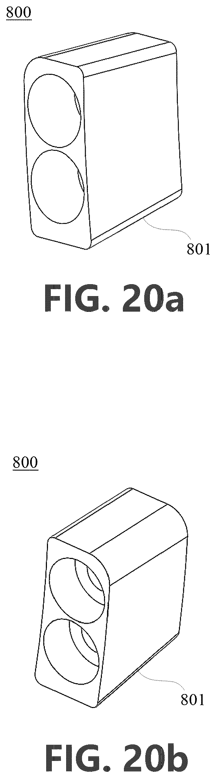

In connection with FIGS. 17 to 20b, the drying apparatus further comprises a uniform flow assembly 700 disposed inside the upper chamber 100. Both ends of the uniform flow assembly 700 are respectively provided with wedge blocks 800, the wedge blocks 800 are fixed in the inside of the upper chamber 100 by boults 810. The surfaces of the wedge blocks 800 and the uniform flow assembly 700 contacting each other are inclined surfaces, and the inclined surfaces 801 of the wedge blocks 800 and the inclined surface of the uniform flow assembly 700 cooperate with each other, so that the uniform flow assembly 700 is clamped into the inside of the upper chamber 100 by the wedge blocks 800.

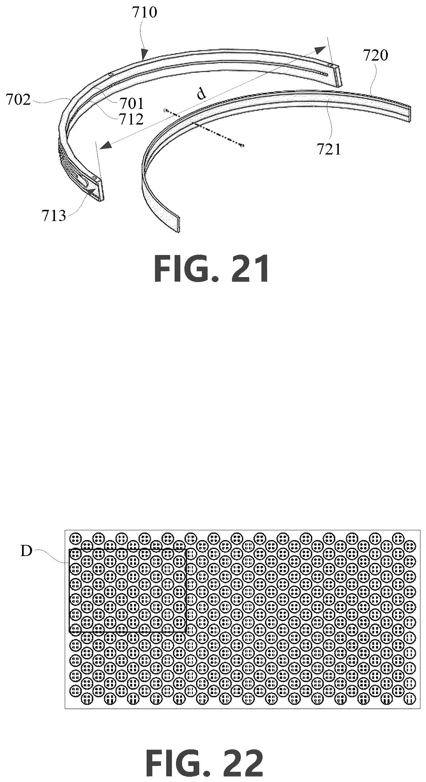

Referring to FIG. 21, the uniform flow assembly 700 comprises an annular gas guiding plate 710 and a porous plate 720. The annular gas guiding plate 710 has a first side surface 701 and a second side surface 702 opposite with each other. The annular gas guiding plate 710 also has a gas guiding groove 712 penetrating the first side surface 701 and the second side surface 702. The distance d between both ends of the gas guiding groove 712 is larger than the diameter of the substrate w. The porous plate 720 is bonded to the first side surface 701 of the annular gas guiding plate 710 by welding. The porous plate 720 comprises a porous structure 721, and the center of the porous structure 721 coincides with the center of the gas guiding groove 712 of the annular gas guiding plate 710. Wherein, the inclined surfaces 801 of the wedge blocks 800 and the inclined surface of the annular gas guiding plate 710 of the uniform flow assembly 700 cooperate with each other.

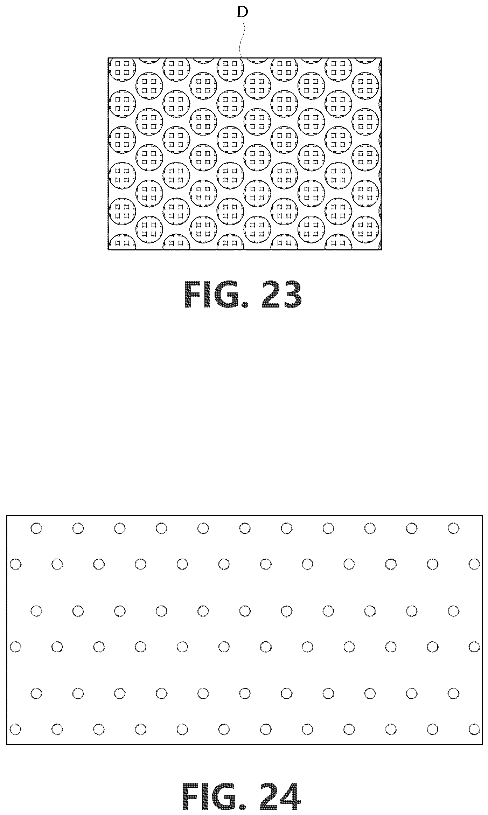

The porous plate 720 may be tailor welded from the body of the porous plate 720 and a sintered mesh (i.e., the porous structure 721). The body of the porous plate 720 may be a stainless steel plate, and the partial structure of the sintered mesh is shown in FIGS. 22 and 23. The sintered mesh adopts the existing five-layer sintered mesh and has a five-layer structure. The sintered mesh is divided into five parts: protective layer, filtration control layer, dispersion layer, supporting skeleton layer and skeleton layer. The sintered mesh has uniform and stable filtration accuracy, high strength and stiffness.

The porous plate 720 may be integrally processed, that is, the body of the porous plate 720 and the porous structure 721 are integrally formed. The body of the porous plate 720 may be made of stainless steel, and a partial enlarged view of the porous structure 721 is shown in FIG. 24.

The use of the porous plate 720 can improve the uniformity of the flow velocity of the supercritical fluid, reduce the turbulent flow of the fluid inside the sealed chamber 120, and achieve the purpose of the supercritical fluid uniformly flowing through the upper surface of the substrate w. Therefore, the uniform flow assembly 700 can be provided in the upper chamber 100, which can make the distribution of the supercritical fluid more uniform.

In connection with FIGS. 21 and 25, the uniform flow assembly 700 further comprises a sealing strip 730 disposed on the second side surface 702 of the annular gas guiding plate 710, so as to be sealed between the annular gas guiding plate 710 and the inner side wall of the upper chamber 100. More specifically, the sealing strip 730 is placed on the annular groove 713 of the second side surface 702 of the annular gas guiding plate 710. The sealing strip 730 is provided with an annular opening 731 for the passage of the supercritical fluid, and the annular opening 731 extends along the longitudinal direction of the sealing strip 730. By adopting the sealing strip 730, the fit between the annular gas guiding plate 710 and the inner side wall of the upper chamber 100 can be improved, and the sealing effect can be achieved. The material of the sealing strip 730 is PTFE material.

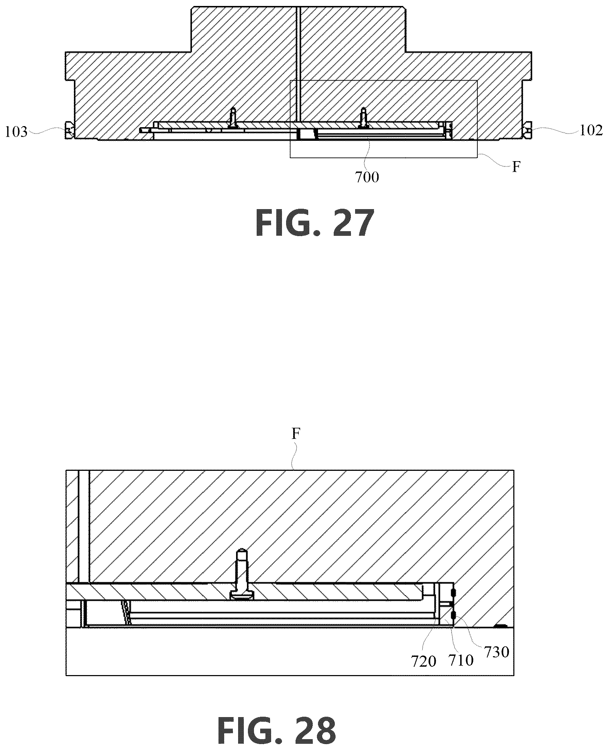

Referring to FIGS. 26 to 28, the supercritical fluid enters from the second fluid inlet 102 and sequentially passes through a plurality of supply through holes 180 and the uniform flow assembly 700 to distribute on the upper surface of the substrate w uniformly. After flowing uniformly through the upper surface of the substrate w, the supercritical fluid continues to be discharged from the sealed chamber 120 through a plurality of discharge through holes 190 and the fluid outlet 103.

When the supercritical fluid passes through the uniform flow assembly 700, the supercritical fluid passes through the sealing strip 730, the annular gas guiding plate 710 and the porous plate 720 sequentially, and then is evenly distributed on the upper surface of the substrate w.

A plurality of supply through holes 180 are disposed on the upper chamber 100 and are horizontally distributed, each supply through hole 180 comprises a gas inlet and a gas outlet. The gas inlets of the supply through holes 180 are connected to the second fluid inlet 102, and the gas outlets of the supply through holes 180 are connected to the uniform flow assembly 700. The second fluid inlet 102 is located on the middle of the first side wall of the upper chamber 100, and the flow velocity of the supercritical fluid at the position of the second fluid inlet 102 is maximum. In order to make the flow velocity of the supercritical fluid in the sealed chamber 120 uniform, a plurality of supply through holes 180 are arranged deviated from the direction of center line of the first side wall, that is, the distance d1 between two adjacent supply through holes 180 close to the second fluid inlet 102 is larger than the distance d2 between the supply through holes 180 away from the second fluid inlet 102 and the supply through holes 180 adjacent to the second fluid inlet 102, so that the supercritical fluid can enter the sealed chamber 120 at a uniform speed. Wherein, the cross-sectional area of the gas inlet of each supply through hole 180 is greater than or equal to the cross-sectional area of the gas outlet. In the present embodiment, the number of the supply through holes 180 is four, and in the actual demand design, the diameters of the supply through holes 180 can be reduced as much as possible, and the number of the supply through holes 180 can be increased.

At present, the upper chamber and the lower chamber are generally only made of nickel-based materials. In the present embodiment, a portion where the upper chamber and the lower chamber are closed to form a sealed chamber is made of stainless steel material. And the portion made of the stainless steel material is subjected to an electrochemical polishing treatment. Stainless steel material is more conducive to an electrochemical polishing than the nickel-based material.

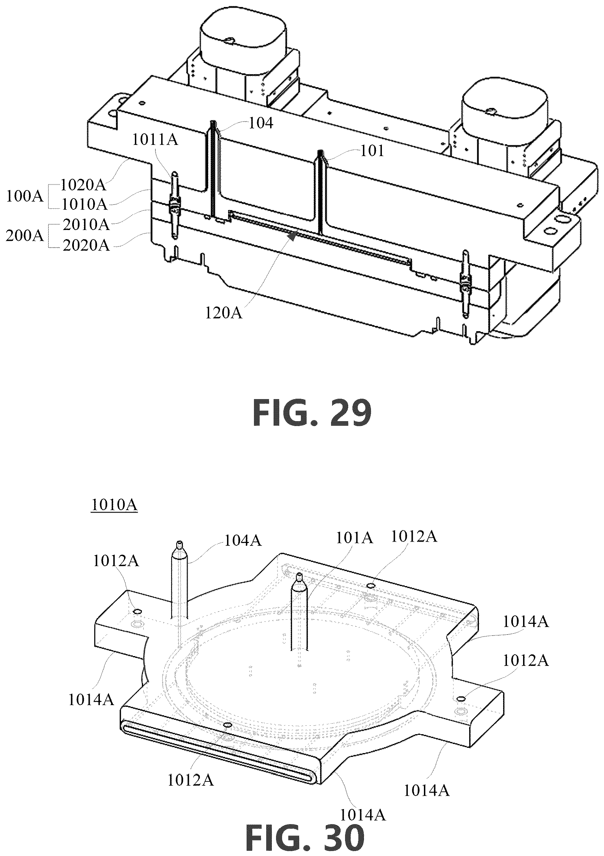

In one embodiment, in connection with FIGS. 29 to 33, the upper chamber 100A and the lower chamber 200A comprise first bodies (1010A, 2010A) and second bodies (1020A, 2020A), respectively. When the upper chamber 100A and the lower chamber 200A are closed, the first body 1010A of the upper chamber 100A and the first body 2010A of the lower chamber 200A form a sealed chamber 120A. Wherein, the first bodies (1010A, 2010A) are nested within the second bodies (1020A, 2020A). The first bodies (1010A, 2010A) are made of stainless steel material, and the second bodies (1020A, 2020A) are made of nickel-based material.

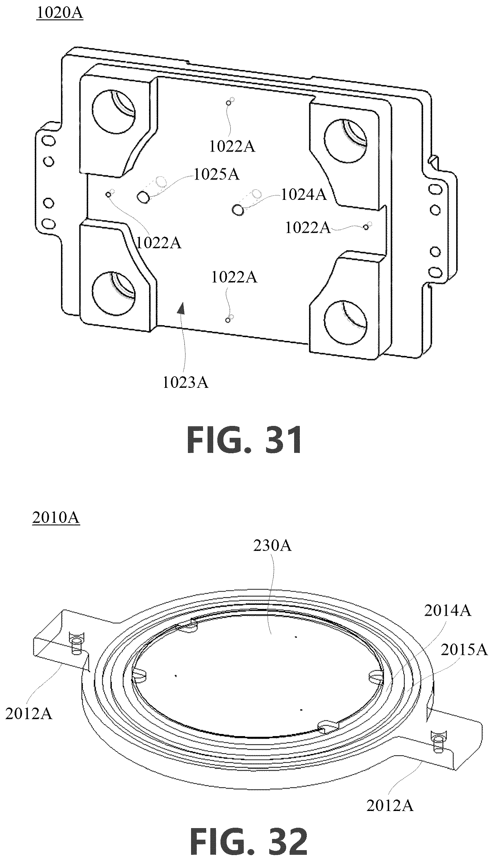

As shown in FIG. 30, the first body 1010A of the upper chamber 100A comprises a plurality of supply through holes, a plurality of discharge through holes, a first fluid inlet 101A and a vacuum pumping inlet 104A. As shown in FIG. 31, the second body 1020A of the upper chamber 100A is provided with an upper chamber receiving groove 1023A for receiving the first body 1010A, a passage 1024A for the first fluid inlet 101A to pass through and a passage 1025A for the vacuum pumping inlet 104A to pass through. The first body 1010A of the upper chamber 100A may be fixed to the second body 1020A by the fasteners 1011A. The first body 1010A may comprise four fixing portions 1014A, each fixing portion 1014A is provided with at least one first fixing hole 1012A. The second body 1020A is provided with at least one second fixing hole 1022A at a position corresponding to the four fixing portions 1014A. The fasteners 1011A fix the first body 1010A to the second body 1020A through the first fixing hole 1012A and the second fixing hole 1022A. The first body 1010A of the upper chamber 100A may be fixed to the second body 1020A by welding.

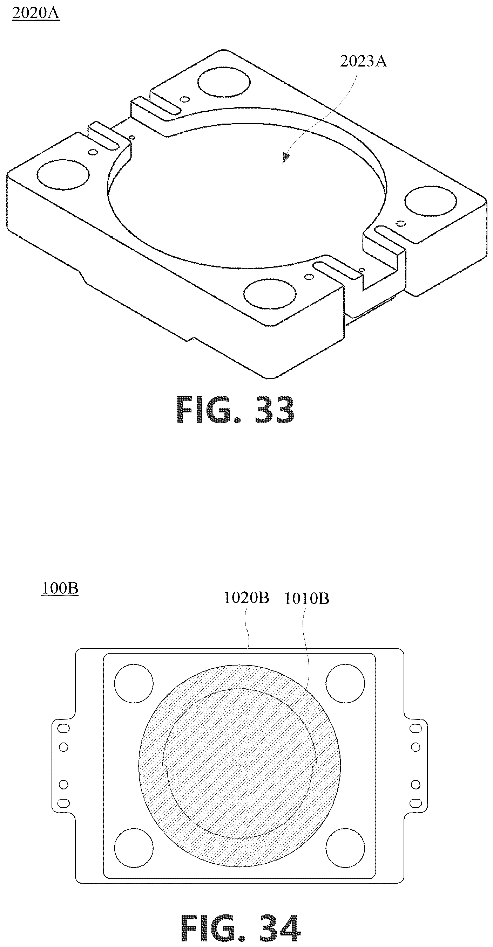

As shown in FIG. 32, the first body 2010A of the lower chamber 200A comprises a substrate tray 230A, an inner annular groove 2014A and an outer annular groove 2015A for placing the inner sealing ring and the outer sealing ring (please refer to the inner sealing ring 210 and outer sealing ring 220 in FIG. 11), respectively. As shown in FIG. 33, the second body 2020A of the lower chamber 200Ais provided with a lower chamber receiving groove 2023A for receiving the first body 2010A. The fixing method between the first body 2010A and the second body 2020A of the lower chamber 200A is the same as the fixing method of the upper chamber 100A, wherein the first body 2010A of the lower chamber 200A may comprise two fixation portions 2012A disposed oppositely.

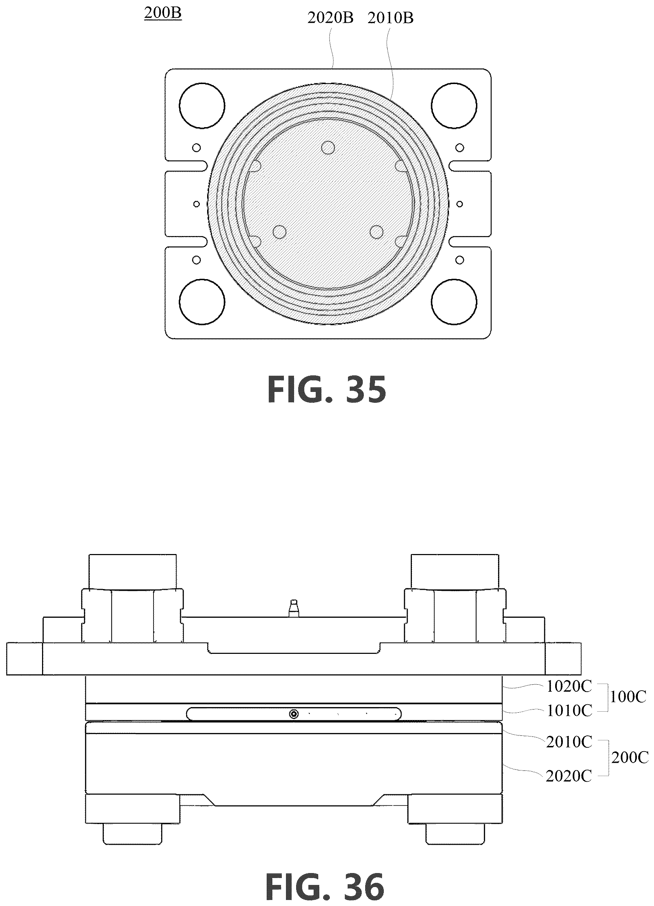

In connection with FIGS. 34 and 35, another embodiment is provided in which the first bodies (1010B, 2010B) of the upper chamber 100B and the lower chamber 200B are nested within the second bodies (1020B, 2020B). In the present embodiment, the middle portions of the upper chamber 100 B and the lower chamber 200B are replaced with stainless steel material, and the middle portions are basically portions in contact with the supercritical fluid. The middle portion of the upper chamber 100B is the first body 1010B, and the middle portion of the lower chamber 200B is the first body 2010B. The first bodies (1010B, 2010B) are made of stainless steel material, and the second bodies (1020B, 2020B) are made of nickel-based material.

As shown in FIG. 34, the hatched portion represents the first body 1010B of the upper chamber 100B. As shown in FIG. 35, the hatched portion represents the first body 2010B of the lower chamber 200B.

Referring to FIG. 36, an embodiment is provided in which the respective first bodies (1010C, 2010C) of the upper chamber 100C and the lower chamber 200C are integrally formed with the second bodies (1020C, 2020C). In this embodiment, the upper chamber 100 C and the lower chamber 200 C both have two layers. The first bodies (1010 C, 2010 C) are stainless steel layers, and the second bodies (1020 C, 2020 C) are nickel-based layers. A composite technology using explosive integrated material can be adopted between the first bodies (1010 C, 2010 C) and the second bodies (1020 C, 2020 C), and the two atoms of nickel-based material and stainless steel material are combined into one by explosion.

It will be understood by those skilled in the art that in other alternative embodiments, under the condition of ensuring the strength of the upper chamber and the lower chamber, the respective first bodies and the second bodies of the upper chamber and the lower chamber may be made of the same material.

### Second embodiment

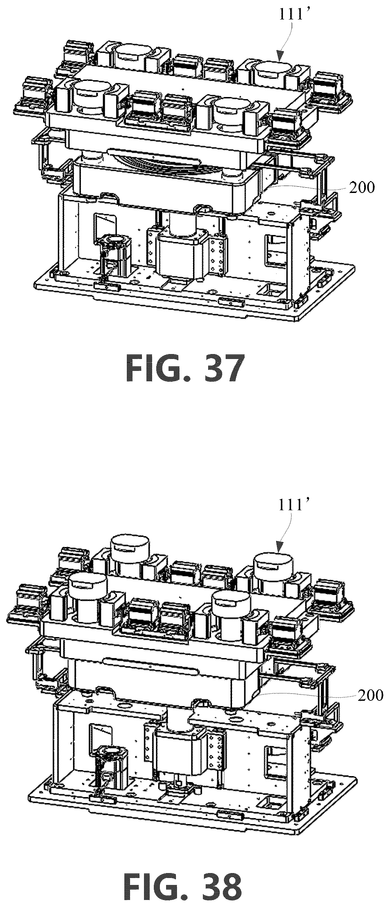

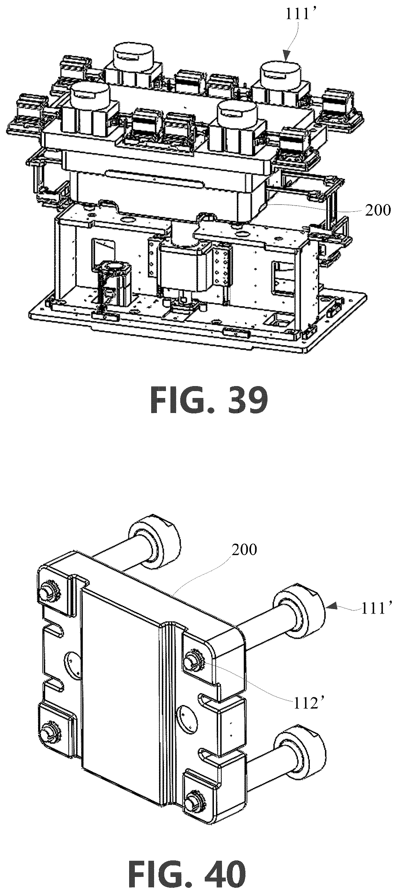

Referring to FIGS. 37 to 40, the second embodiment further provides a drying apparatus for drying a substrate using supercritical fluid, and the difference between the second embodiment and the first embodiment is that:
The connectors 111' of the connecting assemblies are bolts, and the bolts themselves have threads (not shown in the figure). The fixing members of the connecting assemblies comprise screw nuts 112'. The first ends of the bolts are threaded to the lower chamber 200 and pass through the bottom of the lower chamber 200. The screw nuts 112' are threaded to the first ends of the bolts at the bottom of the lower chamber 200.

Other arrangements and connection methods of the present embodiment are the same as arrangements and connection methods of the first embodiment, and will not be repeatedly described here.

### Third embodiment

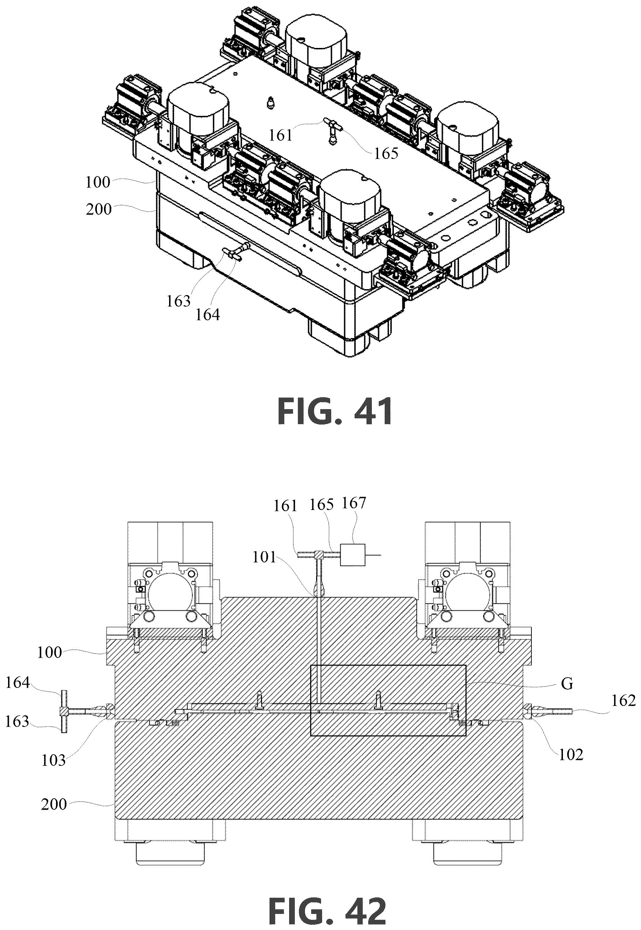

In connection with FIGS. 41 to 43, the third embodiment further provides another drying apparatus for drying a substrate using supercritical fluid, and the difference between the third embodiment and the first or second embodiment is that:
The drying apparatus further comprises a gas discharge pipe 165 and a flow rate meter 167, and the gas discharge pipe 165 and the first fluid supply pipe 161 are respectively independently connected to the first fluid inlet 101 on the top wall of the upper chamber 100. The flow rate meter 167 is provided on the gas discharge pipe 165, for detecting the flow rate of the gas in the gas discharge pipe 165.

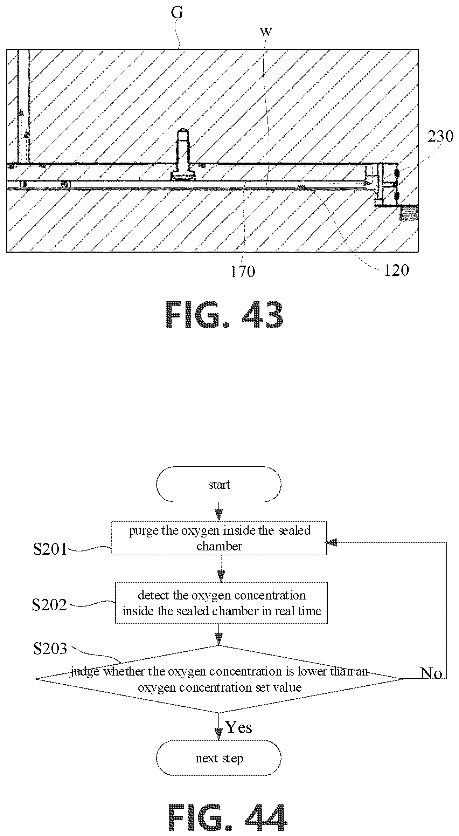

In connection with FIGS. 16, 41 to 47b, based on the above-described drying apparatus, the third embodiment provides a method for drying a substrate using supercritical fluid, the drying method including the following steps:
Step S1: The substrate w to be dried is placed on the substrate tray 230, and the lower chamber 200 and the upper chamber 100 are moved relatively in the vertical direction, so as to be closed into a pressure-resistant sealed chamber 120;
Step S2: The supercritical fluid is supplied from the first fluid inlet 101 above the sealed chamber 120 through the first fluid supply pipe 161. After bypassing the spoiler 170 below the first fluid inlet 101, the fluid reaches the upper surface of the substrate w from the side of the substrate w, so that the pressure value inside the sealed chamber reaches a set pressure value. The supercritical fluid is stopped supplying from above the sealed chamber 120. When the pressure value inside the sealed chamber 120 reaches the set pressure value, it means that the pressure of sealed chamber 120 is increased to more than the critical pressure of the supercritical fluid and reaches a supercritical state;
Step S3: The supercritical fluid is supplied from the second fluid inlet 102 on the first side wall of the sealed chamber 120 through the second fluid supply pipe 162, so that the supercritical fluid is replaced with the isopropyl alcohol (IPA) covered on the surface of the substrate w. The surface of the substrate w inside the sealed chamber 120 is dried, and the treated supercritical fluid is discharged through the fluid outlet 103 on the second side wall of the sealed chamber;
Step S4: After the drying process is completed, the second fluid inlet 102 and the fluid outlet 103 are closed, and the internal pressure of the sealed chamber 120 is reduced. After the supercritical fluid is changed into gas, the gas bypasses the spoiler 170 and is discharged from the sealed chamber 120 at a predetermined and uniform speed from above the sealed chamber 120 through the first fluid inlet 101. A gas discharge pipe 165 is connected to the first fluid inlet 101, so that the gas is discharged from the gas discharge pipe 165. In FIG. 43, the dotted arrow indicates the discharge direction of the supercritical fluid in the sealed chamber 120 after the supercritical fluid becomes the gas in the present embodiment;

In terms of the discharge mode after the supercritical fluid becomes the gas, the gas is generally discharged from the sealed chamber 120 through the fluid discharge pipe 163 by the fluid outlet 103 on the second side wall of the upper chamber 100. However, when the gas bypasses the surface of the substrate w and towards the fluid outlet 103, the gas is discharged in the horizontal direction, and the high-speed gas flow tends to pull down the pattern structures at the edge of the substrate w.

Therefore, in the present embodiment, the discharge mode of the gas is changed, so that after the supercritical fluid becomes the gas and bypasses the edge of the spoiler 170, the supercritical fluid is discharged upward from the sealed chamber 120 at a predetermined and uniform speed through the first fluid inlet 101 and the gas discharge pipe 165 on the top wall of the upper chamber 100. When the high-speed gas flow reaches the edge position of the substrate w, the discharge direction of the high-speed gas flow changes from horizontal to upward, so that the pattern structures at the edge position of the substrate w can be avoided to some extent from being pulled down by the high-speed gas flow running horizontally.

Step S5: When the internal pressure of the sealed chamber 120 reaches the atmospheric pressure state, the sealed chamber 120 is opened and the substrate w is taken out.

In this embodiment, the supercritical fluid is supercritical carbon dioxide.

As shown in FIG. 44, before step S2, the following steps are further included:
S201: The oxygen inside the sealed chamber 120 is purged;
S202: The analyzer 630 detects the oxygen concentration inside the sealed chamber 120 in real time from the fluid outlet 103 on the second side wall of the sealed chamber 120 through the residual gas sampling pipe 164;
S203: It is judged whether the oxygen concentration is lower than an oxygen concentration set value;

If yes, the process proceeds to step S2, that is, the process command system 640 commands the process control system 650 to control the first fluid supply pipe 161 to supply the supercritical fluid to the inside of the sealed chamber 120;

If not, the process returns to step S201.

By controlling the oxygen concentration before the drying process, the substrate w is prevented from being corroded during the subsequent process.

In the above step S3, the concentration of isopropyl alcohol (IPA) is detected in real time, and the drying situation in the sealed chamber 120 is known in real time. Therefore, step S3 further includes: adjusting the pressure in the sealed chamber 120 according to the concentration of isopropyl alcohol detected by the analyzer 630 from the fluid outlet 103 on the second side wall of the sealed chamber 120 in real time, so that the pressure difference between the maximum pressure value and the minimum pressure value of the pressure in the sealed chamber 120 is constant or gradually increases.

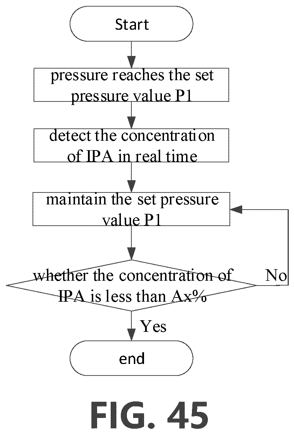

As shown in FIG. 45, when the pressure reaches the set pressure value P1, the flow-through drying process is performed by maintaining the set pressure value P1. The analyzer 630 detects the concentration of isopropyl alcohol (IPA) in real time until the concentration of IPA is less than the final set value Ax%, and the drying process is completed. The process command system 640 commands the process control system 650 to adjust the process parameters of the drying apparatus in a timely manner, for example, proceeding to step S4 to reduce the internal pressure of the sealed chamber 120 and perform a pressure relief process.

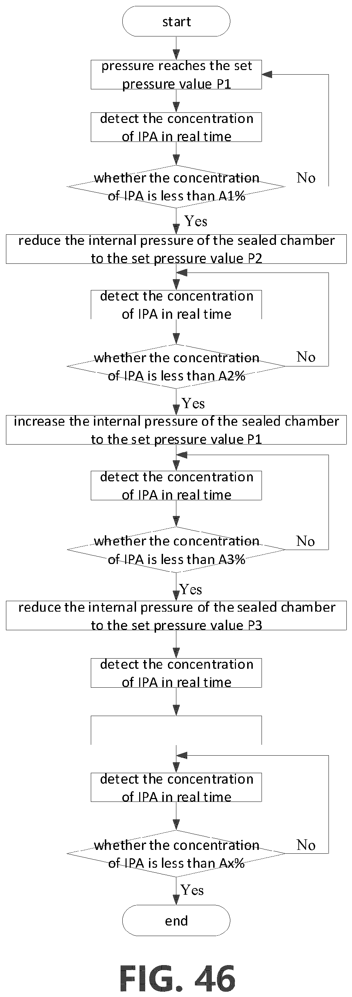

Alternatively, as shown in FIG. 46, when the concentration of isopropyl alcohol (IPA) detected by the analyzer 630 is less than the initial concentration set value A1%, the internal pressure of the sealed chamber 120 is reduced to the set pressure value P2. When the concentration of IPA detected by the analyzer 630 is less than the concentration set value A2%, the internal pressure of the sealed chamber 120 is increased to the set pressure value P1. When the concentration of IPA detected by the analyzer 630 is less than the concentration set value A3%, the internal pressure of the sealed chamber 120 is reduced to the set pressure value P3. When the concentration of IPA detected by the analyzer 630 is less than the concentration set value A4%, the internal pressure of the sealed chamber 120 is increased to the set pressure value P1. When the concentration of IPA detected by the analyzer 630 is less than the concentration set value A5%, the internal pressure of the sealed chamber 120 is reduced to the set pressure value P4. And the cycle is performed until the IPA concentration detected by the analyzer 630 is less than the final set value Ax%. The drying process is completed, and the process command system 640 commands the process control system 650 to adjust the process parameters of the drying apparatus in a timely manner, for example, proceeding to step S4 to reduce the internal pressure of the sealed chamber 120 and perform a pressure relief process.

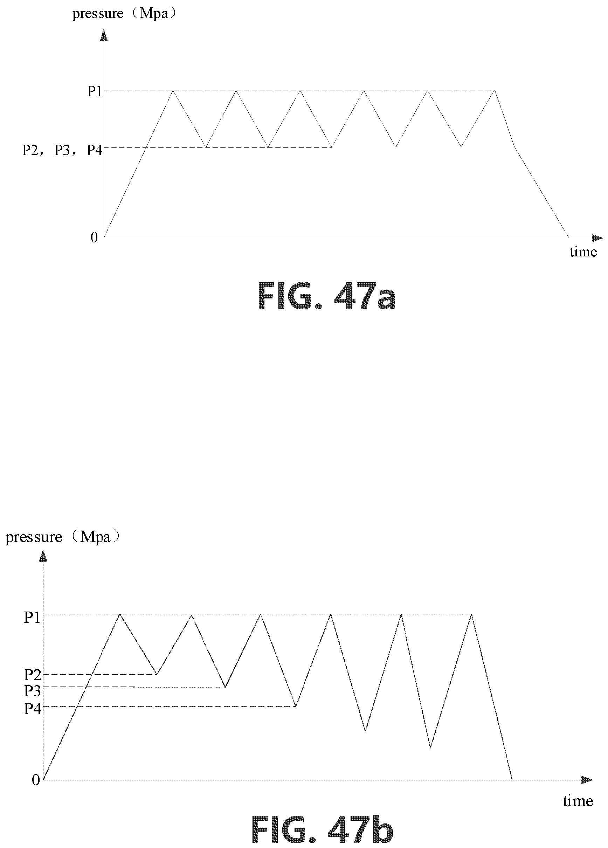

Wherein, as shown in FIG. 47a, the set pressure value P2 = the set pressure value P3 = the set pressure value P4 =... = the set pressure value Px, that is, the pressure difference between the maximum pressure value and the minimum pressure value of the pressure in the sealed chamber 120 is the same. As shown in FIG. 47b, it can also be that the set pressure value P2 > the set pressure value P3 > the set pressure value P4 >... > the set pressure value Px, that is, the pressure difference between the maximum pressure value and the minimum pressure value of the pressure in the sealed chamber 120 may gradually increase. The set pressure value Px, that is, the minimum pressure value, is not lower than the supercritical pressure of the supercritical fluid, and P1, P2,..., Px is not lower than the supercritical pressure of the mixture of supercritical CO2 and IPA under the measurement conditions. The supercritical pressure of the mixture of supercritical CO2 and IPA is different from the supercritical pressure of supercritical CO2 or the supercritical pressure of IPA.

By adjusting the internal pressure of the sealed chamber 120 in the above steps, the pressure in the drying process fluctuates, and the replacement between the IPA and the supercritical fluid can be efficiently promoted. The process efficiency of the drying process of the substrate w can be improved.

### Fourth embodiment

Referring to FIGS. 42 and 43, the fourth embodiment provides another method for drying a substrate using supercritical fluid, and the difference between the fourth embodiment and the third embodiment is that:
In step S4: After the drying process is completed, when the supercritical fluid becomes the gas, the flow rate of the gas in the gas discharge pipe 165 is detected by the flow meter 167. The gas is discharged from the sealed chamber 120 at a first speed, and after a first predetermined time, the surface of the supercritical fluid reaches the lower surface of the spoiler 170. At this time, in order to avoid that high-speed gas flow pulls down the pattern structures at the edge position of the substrate w, the gas discharge speed is slowed down, so that the gas is discharged from the sealed chamber 120 at a second speed. And after a second predetermined time, the surface of the supercritical fluid is lower than the upper surface of the pattern structure of the substrate w. At this time, since the high-speed gas flow is no longer easily pulling down the pattern structures of the substrate w, the gas discharge speed can be increased, so that the gas is discharged from the sealed chamber 120 at a third speed. And after a third predetermined time, the internal pressure of the sealed chamber 120 reaches the atmospheric pressure state, and the gas discharge process is completed.

In the present embodiment, the first speed is greater than the second speed, the third speed is greater than the second speed, and the first speed and the third speed may be the same or different. According to the position of the surface of supercritical fluid, setting different exhaust speeds can not only avoid the high-speed gas flow from pulling down the pattern structures at the edge position of the substrate w, but also ensure the exhaust efficiency.

### Fifth embodiment

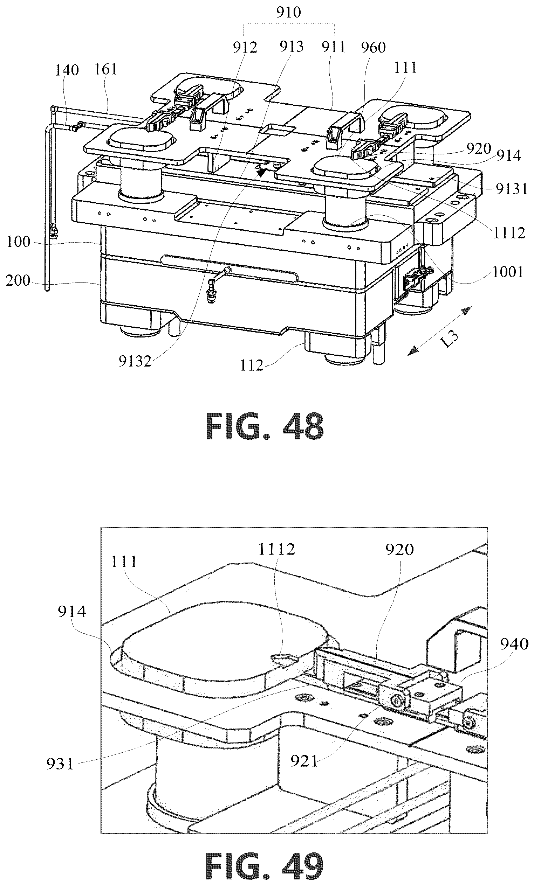

In connection with FIGS. 48 to 51, the assembly tooling provided in the fifth embodiment is used to assemble the connecting assemblies of the drying apparatus in the first embodiment.

The assembly tooling comprises a tooling body 910 and positioning portions 920. The tooling body 910 is fixed to the upper chamber 100, and the tooling body 910 is provided with assembly openings 914 that vertically correspond to the through holes 1001 of the upper chamber 100 and the through holes 2001 of the lower chamber 200 (see the through holes 2001 in FIG. 5a of the first embodiment). The positioning portions 920 are movably provided on the tooling body 910. The number of assembly openings 914 is four, the number of assembly openings is the same as the number of connectors 111 on the connecting assemblies, and the sizes of the assembly openings 914 are suitable for the passage of the connectors 111. The installation number of positioning portions 920 is the same as the number of assembly openings 914.

After the connectors 111 penetrate the upper chamber 100 and the lower chamber 200 through the assembly openings 914 and the through holes (1001, 2001), the positioning portions 920 are aligned with the marking portions 1112 of the connectors 111 by moving the positioning portions 920. The positioning portions 920 are matched with the marking portions 1112, so that the axis of the connectors 111 coincides with the axis of the through holes of the upper chamber 100 and the lower chamber 200, so as to realize the precise positioning of the connectors 111, and facilitate the fixing members of the connecting assemblies, such as the fix of U-shaped clips and screws 113. It is also equivalent to making the normal direction of the connectors 111 parallel to the normal direction of the first locking blocks and the second locking blocks of the locking mechanisms (refer to the first locking blocks 131 and the second locking blocks 132 in FIG. 8a of embodiment 1). Hence, the first locking blocks and the second locking blocks are relatively moved between the top wall surface of the upper chamber 100 and the self-locking surfaces of the connectors 111 (refer to the self-locking surfaces 1103 of the connectors 111 in FIG. 5c of embodiment 1), thereby locking the connectors 111.

The assembly tooling also comprises guiding rails 930, sliding mounting blocks 940 and locating portions 950. The guiding rails 930 are provided on the tooling body 910, and the guiding rails 930 extends towards the assembly openings 914. In the present embodiment, there are two guiding rails 930, both of the guiding rails 930 are linear guiding rails. The tooling body 910 is provided with linear grooves 931 for mounting the guiding rails 930. Both ends of each guiding rail 930 extend towards the assembly openings 914 along the width direction L3 of the upper chamber 100. Each guiding rail 930 is provided with two positioning portions 920, two sliding mounting blocks 940 and two locating portions 950. And each positioning portion 920, sliding mounting block 940 and locating portion 950 corresponds to an assembly opening 914 respectively.

The sliding mounting blocks 940 and the locating portions 950 are all disposed on the guiding rails 930, and the positioning portions 920 are rotatably mounted on the sliding mounting blocks 940 by the pin shafts 921. The sliding mounting blocks 940 drive the positioning portions 920 to slide on the guiding rails 930. The locating portions 950 are positioned at a predetermined position between the sliding mounting blocks 940 and the assembly openings 914. Specifically, the ends of the guiding rails 930 are set to a predetermined position, and the locating portions 950 are fixed to the ends of the guiding rails 930. When the sliding mounting blocks 940 slide to the position of the locating portions 950, the sliding mounting blocks 940 abut against the locating portions 950, so that the positioning portions 920 exactly match the marking portions 1112 of the connectors 111. The predetermined position may be set according to actual process requirements, and the locating portions 950 may be polyurethane positioning blocks.

In other alternative embodiments, modulus holes may be provided at a position corresponding to a predetermined position on the guiding rails 930. The protrusions corresponding to the modulus holes may be provided on the sliding mounting blocks 940. When the sliding mounting blocks 940 slide to a predetermined position on the guiding rails 930, the protrusions match the modulus holes, that is, the positioning portions 920 exactly match the marking portions 1112 of the connectors 111.

As shown in FIG. 48, the tooling body 910 comprises a top plate 911, a vertical plate 912 and a bottom plate 913, and the vertical plate 912 is connected to the top plate 911 and the bottom plate 913. Wherein, the top plate 911 and the bottom plate 913 are respectively perpendicular to the vertical plate 912 and parallel to each other. The bottom plate 913 is used to be fixed to the upper chamber 100, and the assembly openings 914 and the positioning portions 920 are both provided on the top plate 911. In this embodiment, the pin holes 9131 are provided on the bottom plate 913, correspondingly, the pin holes are also provided on the upper chamber 100. And the fasteners fix the bottom plate 913 to the top wall of the upper chamber 100 through the pins hole 9131 of the bottom plate 913 and the pin holes of the upper chamber 100. The bottom plate 913 is also provided with an avoidance space 9132, to avoid the lines such as the first fluid supply pipe 161 and the vacuum pumping pipeline 140 provided on the top wall of the upper chamber 100. In addition, the vertical plate 912 is set at a height that raises the top plate 911, which not only provides an avoidance space for the lines such as the first fluid supply pipe 161 and the vacuum pumping pipeline 140 on the top wall of the upper chamber 100, but also makes the heights of the positioning portions 920 on the top plate 911 match with the heights of the marking portions 1112 on the connectors 111.

In addition, the top plate 911 of the tooling body 910 is provided with handles 960 to facilitate transportation. In the present embodiment, two handles 960 are provided symmetrically.

Hereinafter, taking the connectors 111 of the connecting assemblies as screw rods, and the fixing members of the connecting assemblies use U-shaped clips 112 and screws 113 as an example, the assembly process of the assembly tooling provided in the present embodiment is described.

The marking portions 1112 are provided in advance on the screw caps of the screw rods. The marking portions 1112 may be positioning grooves. The positioning portions 920 of the assembly tooling may be pointers. The shapes of the front ends 9201 of the positioning portions 920 match the shapes of the positioning grooves. The rear ends 9202 of the positioning portions 920 are rotatably mounted on the sliding mounting blocks 940.

Firstly, the assembly tooling is fixed to the top wall of the upper chamber 100 by the bottom plate 913. It should be noted that, before fixing the assembly tooling, the locking mechanisms (see the locking mechanisms 123 in FIG. 1 of embodiment 1) can be mounted to the top wall of the upper chamber 100.

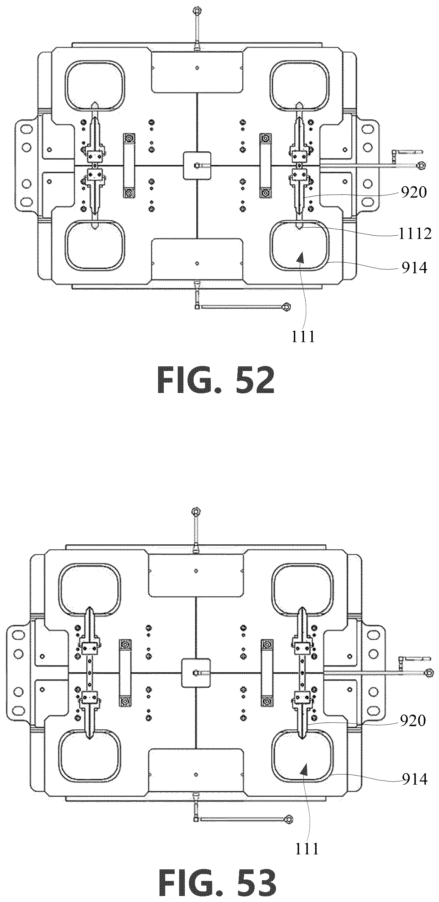

Then, the screw rods are loaded in the upper chamber 100 and the lower chamber 200 from above the top plate 911 via the assembly openings 914, the through holes of the upper chamber 100 and the through holes of the lower chamber 200. FIG. 52 shows before the assembly tooling positions the screw rods.

Then, the sliding mounting blocks 940 are pushed to the position of the locating portions 950, and the pointers can be rotated when needed, to ensure that the lower surfaces of the front ends of the pointers overlap with the bottom surfaces of the positioning grooves of the screw rods. Hence, the pointers match the positioning grooves of the screw rods, that is, the alignment between the pointers and the positioning grooves is completed. At this time, not only the axis of the screw rods coincides with the axis of the through holes of the upper chamber 100 and the lower chamber 200, but also the normal direction of the screw rods is parallel to the normal direction of the first locking blocks and the second locking blocks of the locking mechanisms. The precise positioning of the screw rods is realized, which is convenient for the screws 113 to be accurately fixed at the corresponding position of the bottom of the lower chamber 200 by the screw holes of the U-shaped clips 112, and also for the relative movement of the first locking blocks and the second locking blocks between the top wall surface of the upper chamber 100 and the self-locking surfaces of the screw rods, so as to lock the screw rods. FIG. 53 shows after assembly tooling positions the screw rods.

After the pointers are aligned with the positioning grooves of the screw rods, the U-shaped clips are clamped into the clamping slots of the screw rods, and the screws 113 are used to accurately pass through the screw holes of the U-shaped clips 112 and the corresponding screw holes at the bottom of the lower chamber 200. The screw rods are fixed to the lower chamber 200 to complete the assembly of screw rods.

After the screw rods are precisely fixed to the lower chamber 200, the pointers can be lifted and rotated around the pin shafts 921 to leave the positioning grooves, or the sliding mounting blocks 940 can be pulled to exit the pointers from the positioning grooves.

Finally, the assembly tooling that has completed the assembly work is detached from the top wall of the upper chamber 100, and the assembly tooling is removed from the upper chamber 100 by the handles 960.

Finally, it should be noted that the above embodiments are merely used to illustrate the technical solutions of the present invention, and are not intended to limit the technical solutions. Although the present invention has been described in detail with reference to the above-described embodiments, those of ordinary skill in the art will understand that the technical solutions described in the above-described embodiments may be modified, or some or all of the technical features may be equivalently replaced. However, these modifications or substitutions do not cause the essence of the corresponding technical solutions to deviate from the scope of the technical solutions of each embodiment of the present invention.

## Claims

1. A drying apparatus for drying a substrate using supercritical fluid, comprising:
an upper chamber and a lower chamber, the lower chamber being disposed below the upper chamber;
a substrate tray, disposed on the lower chamber, used for carrying the substrate;
a lifting mechanism, disposed below the lower chamber, used for driving the lower chamber to move in the vertical direction;
a connecting assembly and a locking mechanism, the connecting assembly connecting the upper chamber and the lower chamber, the locking mechanism being used for locking or loosening the connecting assembly;
when the lifting mechanism lifts the lower chamber to move upward, so that the lower chamber and the upper chamber are completely contacted, the locking mechanism locks the connecting assembly in the horizontal direction, and a gap is formed between the locking mechanism and the connecting assembly in the vertical direction, when the lifting mechanism withdraws from the lower chamber, the locking mechanism and the connecting assembly contact automatically in the vertical direction, and the upper chamber and the lower chamber are closed to form a sealed chamber;
when the sealed chamber is opened, the lifting mechanism firstly lifts the lower chamber to move upward, the gap is formed between the locking mechanism and the connecting assembly in the vertical direction, and the locking mechanism loosens the connecting assembly in the horizontal direction, and the lifting mechanism lifts the lower chamber to move downward.

2. The drying apparatus according to claim 1, wherein the connecting assembly comprises a connector and a fixing member, the upper chamber and the lower chamber are respectively provided with through holes, the connector penetrate the upper chamber and the lower chamber through the through holes, and the first end of the connector is fixed to the lower chamber through the fixing member;
the locking mechanism is disposed on the upper chamber, and the locking mechanism comprises a first driving portion, a first locking block, a second driving portion and a second locking block located on the two sides of the connector, the first driving portion drives the first locking block, the second driving portion drives the second locking block, so that the first locking block and the second locking block move relatively or backward on the upper chamber in the horizontal direction, so as to lock or loosen the connector.

3. The drying apparatus according to claim 2, wherein the connector is a bolt, and the first end of the bolt is threaded with the lower chamber;
the fixing member is at the bottom of the lower chamber and threaded with the first end of the bolt.

4. The drying apparatus according to claim 2, wherein the connector is a screw rod;
the fixing member is clamped with the first end of the screw rod and fixed at the bottom of the lower chamber.

5. The drying apparatus according to claim 1, wherein the lifting mechanism comprising:
a lifting platform, disposed below the lower chamber, used for lifting the lower chamber;
a driving apparatus and a transmission apparatus, the driving apparatus drives the lifting platform to move upward or downward by the transmission apparatus.

6. The drying apparatus according to claim 5, wherein the driving apparatus is a servo motor.

7. The drying apparatus according to claim 1, wherein the lifting mechanism comprises a six-degree-of-freedom robotic platform, a gear screw transmission mechanism, a servo hydraulic system, an electric cylinder or a gas cylinder.

8. The drying apparatus according to claim 1, further comprising:
a sensor, configured to judge whether the upper chamber and the lower chamber are closed by detecting a distance between the upper chamber and the lower chamber.

9. The drying apparatus according to claim 1, further comprising:
an inner sealing ring and an outer sealing ring, sequentially disposed around the periphery of the substrate tray, when the lower chamber and the upper chamber being relatively moved to close into the sealed chamber, a cavity being formed between the inner sealing ring and the outer sealing ring; wherein,
the longitudinal section of the inner sealing ring is U-shaped, and a spring is arranged inside the inner sealing ring, for causing both the lower chamber and the upper chamber to fit with the inner sealing ring.

10. The drying apparatus according to claim 9, further comprising:
a vacuum pumping pipeline, connected to the cavity through a vacuum pumping inlet provided on the top wall of the upper chamber, so as to perform a vacuum pumping on the cavity, and a pressure detector being provided on the vacuum pumping pipeline, for detecting the pressure of the cavity;
a host computer, used to receive the pressure signal detected by the pressure detector, so as to determine whether the inner sealing ring and the outer sealing ring are failed; wherein, when the vacuum pumping pipeline stops performing a vacuum pumping on the cavity, if the pressure of the pressure detector received by the host computer rises and is less than or equal to atmospheric pressure, the host computer determines that the sealing of the outer sealing ring has failed;
if the pressure of the pressure detector received by the host computer rises and is greater than atmospheric pressure, the host computer determines that the sealing of the inner sealing ring has failed;
if the pressure of the pressure detector received by the host computer is greater than the working pressure of the pressure detector, the host computer controls the vacuum pumping pipeline to stop vacuum pumping.

11. The drying apparatus according to claim 1, further comprising:
a first fluid supply pipe, connected to a first fluid inlet disposed on the top wall of the upper chamber, used for supplying supercritical fluid to the inside of the sealed chamber, such that the sealed chamber being brought to a supercritical state from an atmospheric pressure state;
a second fluid supply pipe, connected to a second fluid inlet disposed on the first side wall of the upper chamber, used for supplying the supercritical fluid to the inside of the sealed chamber in a supercritical state, and performing a drying process on the substrate inside the sealed chamber;
a fluid discharge pipe and a residual gas sampling pipe, both connected to a fluid discharge port disposed on the second side wall of the upper chamber;
an analyzer, connected to the residual gas sampling pipe, for detecting the concentration of the target substance discharged from the sealed chamber in real time;
a controller, used for controlling the process parameters of the drying apparatus according to the concentration of the target substance detected by the analyzer.

12. The drying apparatus according to claim 11, wherein the target substance is oxygen or isopropyl alcohol (IPA).

13. The drying apparatus according to claim 11, further comprising:
a gas discharge pipe, connected to the first fluid inlet disposed on the top wall of the upper chamber, for discharging the supercritical fluid that turns into gas;
a flow rate meter, disposed on the gas discharge pipe, used to detect the flow rate of the gas in the gas discharge pipe.

14. The drying apparatus according to claim 11, further comprising:
a uniform flow assembly, disposed inside the upper chamber, the uniform flow assembly comprising an annular gas guiding plate and a porous plate, the annular gas guiding plate having a first side surface and a second side surface opposite with each other and a guiding groove penetrating the first side surface and the second side surface, the porous plate being fixed to the first side surface of the annular gas guiding plate, the porous plate comprising a porous structure;
when the second fluid supply pipe supplies the supercritical fluid to the inside of the sealed chamber, the supercritical fluid sequentially passes through the gas guiding groove and the porous plate and then distributed on the upper surface of the substrate.

15. The drying apparatus according to claim 14, wherein the porous plate further comprises a body, and the body of the porous plate is spliced with the porous structure; alternatively, the body of the porous plate is integrally formed with the porous structure.

16. The drying apparatus according to claim 14, wherein the uniform flow assembly further comprises:
a sealing strip, disposed on the second side surface of the annular gas guiding plate, so as to be sealed between the annular gas guiding plate and the inner side wall of the upper chamber, the sealing strip being provided with an annular opening for the passage of the supercritical fluid, the annular opening extending along the longitudinal direction of the sealing strip.

17. The drying apparatus according to any one of claims 14 to 16, wherein both ends of the uniform flow assembly are respectively provided with wedge-shaped blocks, the wedge-shaped blocks are fixed in the upper chamber, and the uniform flow assembly is clamped into the inside of the upper chamber by the wedge-shaped blocks.

18. The drying apparatus according to claim 11 or 14, wherein the upper chamber is further provided with a plurality of supply through holes that horizontally distributed, each supply through hole comprises a gas inlet and a gas outlet, the gas inlets of the supply through holes are connected to the second fluid inlet, and the gas outlets of the supply through holes are connected to the uniform flow assembly; wherein,
among a plurality of supply through holes, the distance between two adjacent supply through holes close to the second fluid inlet is greater than the distance between the supply through holes away from the second fluid inlet and the adjacent supply through holes.

19. The drying apparatus according to claim 18, wherein the cross-sectional area of the gas inlet of each supply through hole is greater than or equal to the cross-sectional area of the gas outlet.

20. The drying apparatus according to claim 1, wherein the upper chamber and the lower chamber respectively comprise a first body and a second body, when the upper chamber and the lower chamber are closed, the first body of the upper chamber and the first body of the lower chamber are formed into the sealed chamber;
wherein, the first bodies of the upper chamber and the lower chamber are nested within the respective second bodies, or the first bodies are integrally formed with the second bodies.

21. The drying apparatus according to claim 20, wherein the first bodies are made of stainless steel material, and the second bodies are made of nickel-based material.

22. A drying apparatus for drying a substrate using supercritical fluid, comprising:
an upper chamber and a lower chamber, the lower chamber being disposed below the upper chamber, and the lower chamber moving relatively with the upper chamber in the vertical direction, so as to be closed to form a sealed chamber;
a substrate tray, disposed on the lower chamber, used for carrying the substrate;
a uniform flow assembly, disposed inside the upper chamber, the uniform flow assembly comprising an annular gas guiding plate and a porous plate, the annular gas guiding plate having a first side surface and a second side surface opposite with each other and a gas guiding groove penetrating the first side surface and the second side surface, the porous plate being fixed to the first side surface of the annular gas guiding plate, the porous plate comprising a porous structure, and the supercritical fluid being distributed on the upper surface of the substrate by the gas guiding groove and the porous plate sequentially.

23. The drying apparatus according to claim 22, wherein the porous plate further comprises a body, and the body of the porous plate is spliced with the porous structure; alternatively, the body of the porous plate is integrally formed with the porous structure.

24. The drying apparatus according to claim 22, wherein the uniform flow assembly further comprises:
a sealing strip, disposed on the second side surface of the annular gas guiding plate, so as to be sealed between the annular gas guiding plate and the inner side wall of the upper chamber, the sealing strip being provided with an annular opening for the passage of the supercritical fluid, the annular opening extending along the longitudinal direction of the sealing strip.

25. The drying apparatus according to any one of claims 22 to 24, wherein both ends of the uniform flow assembly are respectively provided with wedge-shaped blocks, the wedge-shaped blocks are fixed in the upper chamber, and the uniform flow assembly is clamped into the inside of the upper chamber through the wedge-shaped blocks.

26. An assembly tooling, wherein the assembly tooling is used for assembling the connecting assembly of the drying apparatus according to claim 4, the connector of the connecting assembly is provided with a marking portion in advance, the assembly tooling comprising:
a tooling body, being fixed to the upper chamber, provided with an assembly opening, and the assembly opening being corresponding to the through holes of the upper chamber and the lower chamber;
a positioning portion, movably provided on the tooling body;
after the connector penetrates the upper chamber and the lower chamber through the assembly opening and the through holes, the positioning portion is matched with the marking portion of the connector by moving the positioning portion, so that the axis of the connector coincides with the axis of the through holes.

27. The assembly tooling according to claim 26, further comprising:
a guiding rail, disposed on the tooling body, the guiding rail extending towards the assembly opening;
a sliding mounting block, disposed on the guiding rail, the positioning portion being rotatably installed on the sliding mounting block, and the sliding mounting block driving the positioning portion to slide on the guiding rail.

28. The assembly tooling according to claim 27, further comprising:
a locating portion, disposed on the guiding rail, and positioned at a predetermined position between the sliding mounting block and the assembly opening.

29. The assembly tooling according to claim 26, wherein the tooling body comprises a top plate, a vertical plate and a bottom plate, the vertical plate is connected to the top plate and the bottom plate, wherein, the top plate and the bottom plate are respectively perpendicular to the vertical plate and parallel to each other, the bottom plate is fixed to the upper chamber, and the assembly opening and the positioning portion are both disposed on the top plate.

30. The assembly tooling according to claim 29, further comprising:
a handle, fixed to the top plate of the tooling body.

31. A drying method for drying a substrate using supercritical fluid, comprising the following steps:
Step S1: place the substrate to be dried on the substrate tray, causing the lower chamber and the upper chamber to move relatively in the vertical direction, so as to be closed into a pressure-resistant sealed chamber;
Step S2: supply the supercritical fluid from the first fluid inlet above the sealed chamber through the first fluid supply pipe, and the fluid bypasses the spoiler below the first fluid supply pipe and reaches the upper surface of the substrate from the side of the substrate; after the pressure value inside the sealed chamber reaches a set pressure value, stop supplying the supercritical fluid from above the sealed chamber;
Step S3: supply the supercritical fluid from the second fluid inlet on the first side wall of the sealed chamber through the second fluid supply pipe, perform a drying process on the substrate, and discharge the supercritical fluid from the fluid outlet on the second side wall of the sealed chamber;
Step S4: after the drying process is completed, close the second fluid inlet and the fluid outlet, reduce the internal pressure of the sealed chamber; after the supercritical fluid is turned into gas, the gas bypasses the spoiler and is discharged from above the sealed chamber at a predetermined speed through the first fluid inlet;
Step S5: after the internal pressure of the sealed chamber reaches the atmospheric pressure state, open the sealed chamber and take out the substrate.

32. The drying method according to claim 31, wherein in the step S4, after the supercritical fluid is turned into gas, the gas bypasses the spoiler and is discharged from above the sealed chamber at a predetermined and uniform speed through the first fluid inlet.

33. The drying method according to claim 31, wherein in the step S4, in the process of turning the supercritical fluid into gas, the gas is first discharged at a first speed; when the surface of the supercritical fluid reaches the lower surface of the spoiler, the gas is discharged at a second speed, and when the surface of the supercritical fluid is lower than the upper surface of pattern structures of the substrate, the gas is discharged at a third speed, until the internal pressure of the sealed chamber reaches the atmospheric pressure state, wherein, the first speed > the second speed, and the third speed > the second speed.

34. The drying method according to any one of claims 31 to 33, before the step S2, further comprising the following steps:
S201: purge the oxygen inside the sealed chamber;
S202: detect the oxygen concentration inside the sealed chamber in real time from the fluid outlet on the second side wall of the sealed chamber;
S203: determine whether the oxygen concentration is lower than an oxygen concentration set value;
If yes, the process proceeds to the step S2;
If not, the process returns to the step S201.

35. The drying method according to any one of claims 31 to 33, wherein the step S3 further comprises the following steps:
according to the concentration of isopropyl alcohol detected in real time from the fluid outlet on the second side wall of the sealed chamber, adjust the internal pressure of the sealed chamber, such that the pressure difference between the maximum pressure value and the minimum pressure value of the internal pressure of the sealed chamber is the same or gradually increases.
